# EUROPEAN PATENT APPLICATION

(11) **EP 4 506 756 A1**
(43) Date of publication of application: **12.02.2025**
(21) Application number: 23791935.2
(22) Date of filing: 21.04.2023
(51) Int. Cl.: G03F 7/11, G03F 7/20, G03F 7/26

(54) **COMPOSITION FOR RESIST UNDERLAYER FILM FORMATION**

(30) Priority: 22.04.2022 JP 2022070865
(71) Applicant: Nissan Chemical Corporation, Tokyo 103-6119 (JP)
(72) Inventor: MARUYAMA, Daisuke, Kaohsiung City, 82151 (TW); ENDO, Takafumi, Toyama-shi, Toyama 939-2792 (JP); KISHIOKA, Takahiro, Toyama-shi, Toyama 939-2792 (JP)
(74) Representative: Müller-Boré & Partner Patentanwälte PartG mbB
(86) International application number: PCT/JP2023/015845
(87) International publication number: WO 2023/204287

(57) **Abstract**

There is provided a composition for forming a resist underlayer film containing a polymer having a repeating unit (1) represented by Formula (1) below and a repeating unit (2) other than the repeating unit (1), and a solvent, in which an average particle size of the polymer in a polymer solution containing the polymer is 50 nm or less.

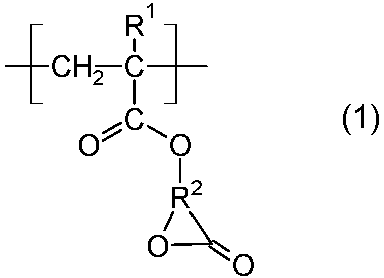

(In Formula (1), R₁ represents a hydrogen atom, a methyl group, or a halogen atom, and R₂ represents a trivalent hydrocarbon group having 3 to 6 carbon atoms. Here, the lactone structure containing R₂ is a 5-membered ring or a 6-membered ring.)

## Description

### Technical Field

The present invention relates to a composition for forming a resist underlayer film, a resist underlayer film, a semiconductor processing substrate, a method for manufacturing a semiconductor element, and a pattern forming method.

### Background Art

Conventionally, fine processing by lithography using a photoresist composition has been performed in the manufacturing of semiconductor devices. The fine processing is a processing method of forming a thin film of a photoresist composition on a silicon wafer, irradiating the thin film with active energy rays such as ultraviolet rays through a mask pattern on which a pattern of a semiconductor device is drawn, developing the thin film, and etching the silicon wafer using the obtained resist pattern as a protective film.

However, in recent years, the degree of integration of semiconductor devices has been increased, and active energy rays to be used also tend to be shortened from KrF excimer lasers (248 nm) to ArF excimer lasers (193 nm). Accordingly, the influence of diffuse reflection of active energy rays from the substrate and standing waves is a major problem. Therefore, a method of providing a bottom anti-reflective coating (BARC), which is a resist underlayer film, between a photoresist and a substrate has been widely studied.

For example, the present applicant has proposed an antireflection film forming composition which has a high antireflection light effect, does not cause intermixing with a resist layer, can obtain an excellent resist pattern and a wide focus depth margin, and can obtain an antireflection film for lithography having a higher dry etching rate than a resist (refer to Patent Literature 1).

### Citation List

### Patent Literature

Patent Literature 1: WO2003/017002

### Summary of Invention

### Technical Problem

The present inventors have found that when a resist underlayer film obtained from a composition for forming a resist underlayer film is etched while the composition described in WO 2003/017002 is used as a composition for forming a resist underlayer film, fine particulate etching residues may be generated. The generation of etching residues may reduce the yield of semiconductor elements.

An object of the present invention is to provide a composition for forming a resist underlayer film, a resist underlayer film, a semiconductor processing substrate, a method for manufacturing a semiconductor element, and a pattern forming method capable of suppressing generation of fine particulate etching residues.

### Solution to Problem

As a result of intensive studies to solve the above problems, the present inventors have found that the above problems can be solved, and have completed the present invention having the following gist.

That is, the present invention includes the following.
[1] A composition for forming a resist underlayer film containing a polymer having a repeating unit (1) represented by Formula (1) below and a repeating unit (2) other than the repeating unit (1), and a solvent, in which
   an average particle size of the polymer in a polymer solution containing the polymer is 50 nm or less. 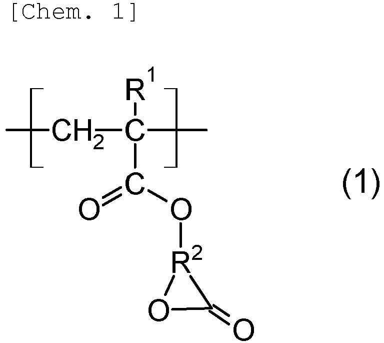
   (In Formula (1), R¹ represents a hydrogen atom, a methyl group, or a halogen atom, and R² represents a trivalent hydrocarbon group having 3 to 6 carbon atoms. Here, the lactone structure containing R² is a 5-membered ring or a 6-membered ring.)
[2] The composition for forming a resist underlayer film according to [1], in which the repeating unit (2) includes a repeating unit (2A) represented by Formula (2A) below. 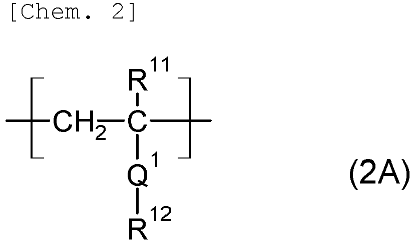 (In Formula (2A), R¹¹ represents a hydrogen atom, a methyl group, or a halogen atom, Q¹ represents a single bond or a divalent linking group, and R¹² represents a hydrogen atom or a monovalent organic group.)
[3] The composition for forming a resist underlayer film according to [1] or [2], in which the repeating unit (2) includes a repeating unit (2A-1) represented by Formula (2A-1) below and a repeating unit (2A-2) represented by Formula (2A-2) below. 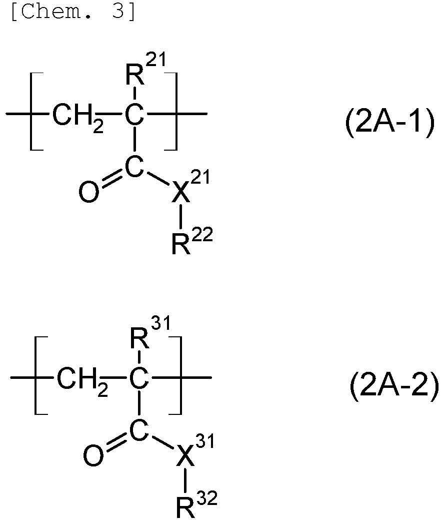
   (In Formula (2A-1), X²¹ represents -O- or -N(-R)- (R represents a hydrogen atom or an alkyl group having 1 to 4 carbon atoms). R²¹ represents a hydrogen atom, a methyl group, or a halogen atom, and R²² represents a substituted or unsubstituted alkyl group having 1 to 10 carbon atoms.
   In Formula (2A-2), X³¹ represents -O- or -N(-R)- (R represents a hydrogen atom or an alkyl group having 1 to 4 carbon atoms). R³¹ represents a hydrogen atom, a methyl group, or a halogen atom, and R³² represents a substituted or unsubstituted aralkyl group, a substituted or unsubstituted carbocyclic aromatic group, or a substituted or unsubstituted heterocyclic aromatic group.)
[4] The composition for forming a resist underlayer film according to [3], in which
   in the polymer, a weight ratio of the repeating unit (1) to all repeating units is 1 to 75% by weight, and
   in the polymer, the total weight ratio of the repeating unit (2A-1) and the repeating unit (2A-2) to all total repeating units is 25 to 99% by weight.
[5] The composition for forming a resist underlayer film according to any one of [1] to [4], in which the polymer has a weight average molecular weight of 50,000 or less.
[6] The composition for forming a resist underlayer film according to any one of [1] to [5], further containing a crosslinking agent.
[7] The composition for forming a resist underlayer film according to any one of [1] to [6], further containing a curing catalyst.
[8] A resist underlayer film which is a cured product of the composition for forming a resist underlayer film according to any one of [1] to [7].
[9] A semiconductor processing substrate including:
   a semiconductor substrate; and
   the resist underlayer film according to [8].
[10] A method for manufacturing a semiconductor element, the method including:
   a step of forming a resist underlayer film on a semiconductor substrate using the composition for forming a resist underlayer film according to any one of [1] to [7]; and
   a step of forming a resist film on the resist underlayer film.
[11] A pattern forming method including:
   a step of forming a resist underlayer film on a semiconductor substrate using the composition for forming a resist underlayer film according to any one of [1] to [7];
   a step of forming a resist film on the resist underlayer film;
   a step of irradiating the resist film with light or electron beam, and then developing the resist film to obtain a resist pattern; and
   a step of etching the resist underlayer film using the resist pattern as a mask.

### Advantageous Effects of Invention

According to the present invention, it is possible to provide a composition for forming a resist underlayer film, a resist underlayer film, a semiconductor processing substrate, a method for manufacturing a semiconductor element, and a pattern forming method capable of suppressing generation of fine particulate etching residues.

### Brief Description of Drawings

Fig. 1A is a particle size distribution of a sample 1st of a polymer solution of Synthesis Example 1.
Fig. 1B is a particle size distribution of a sample 2nd of the polymer solution of Synthesis Example 1.
Fig. 1C is a particle size distribution of a sample 3rd of the polymer solution of Synthesis Example 1.
Fig. 2A is a particle size distribution of a sample 1st of a polymer solution of Synthesis Example 2.
Fig. 2B is a particle size distribution of a sample 2nd of the polymer solution of Synthesis Example 2.
Fig. 2C is a particle size distribution of a sample 3rd of the polymer solution of Synthesis Example 2.

### Description of Embodiments

### (Composition for Forming Resist Underlayer Film)

A composition for forming a resist underlayer film of the present invention contains a polymer and a solvent.

The composition for forming a resist underlayer film may contain other components.

The average particle size of the polymer in the polymer solution containing the polymer is 50 nm or less.

The present inventors have found that when a resist underlayer film obtained from a composition for forming a resist underlayer film is etched while the composition described in WO 2003/017002 is used as a composition for forming a resist underlayer film, fine particulate etching residues may be generated. The generation of etching residues may reduce the yield of semiconductor elements.

Examples of the cause of the etching residues include metal impurities in the composition. However, as a result of examination by the present inventors, the fine particulate etching residues are not caused by metal impurities.

As a result of further studies by the present inventors, it has been found that the polymer contained in the composition for forming a resist underlayer film affects the fine particulate etching residues. It was found that there was a part difficult to be etched in the polymer, and the part caused etching residues.

The present inventors have focused on a monomer (hereinafter may be referred to as a "lactone structure-containing monomer") having a lactone structure and a polymerizable unsaturated bond, which constitute a polymer.

In general, in a multicomponent polymer synthesized by radical polymerization using two or more types of monomers, copolymerization reactivity ratios between the monomers are different, and thus copolymerization composition ratios of polymers generated in an early stage of polymerization and a late stage of polymerization are different, and a finally obtained polymer has a composition distribution.

The lactone structure-containing monomer has a higher polymerization rate in copolymerization than other monomers. Therefore, as described in Example (for example, Synthesis Examples 1 to 5) of WO2003/017002, when two or more types of monomers are mixed at once and polymerized according to the composition ratio in the finally obtained polymer, it is considered that a relatively large amount of the lactone structure-containing monomer is consumed in the initial stage of polymerization, and as a result, repeating units derived from the lactone structure-containing monomer are unevenly distributed in the polymer chain generated in the initial stage of polymerization. When the repeating unit derived from the lactone structure-containing monomer is unevenly distributed in the polymer chain, entanglement of the polymer chain increases. As a result, this is considered to decrease the solubility of the polymer and increase the average particle size of the polymer in the polymer solution.

As a result of further studies, the present inventors have found that fine particulate etching residues are suppressed by using a polymer having a small average particle size in a polymer solution as a polymer contained in a composition for forming a resist underlayer film, and have completed the present invention.

In the present invention, the average particle size of the polymer in the polymer solution containing the polymer is 50 nm or less, preferably 40 nm or less, more preferably 30 nm or less, and particularly preferably 20 nm or less.

The lower limit of the average particle size of the polymer is not particularly limited, but may be 1 nm or more, 2 nm or more, or 5 nm or more.

The average particle size of the polymer in the polymer solution can be determined by dynamic light scattering measurement.

The dynamic light scattering measurement is performed using, for example, a dynamic light scattering photometer DLS-8000Ar (manufactured by Otsuka Electronics Co., Ltd.). Measurement is performed at a scattering angle of 90° using a He-Ne laser (optical wavelength: 633 nm) as incident light, and an autocorrelation function is obtained. With respect to the obtained autocorrelation function, the average particle size and the polydispersity index can be determined by cumulant analysis using an analysis program attached to the above measuring apparatus. Particle size distribution analysis can be performed by the Contin method.

The above polydispersity index of the present invention is, for example, 0.25 or less, 0.24 or less, 0.23 or less, 0.22 or less, 0.21 or less, 0.20 or less, 0.18 or less, or 0.15 or less.

The number of fine particulate etching residues (Cone defect number) indicated by the composition of the present invention is, for example, 2,500 or less, 2,300 or less, 2,000 or less, 1,500 or less, 1,000 or less, 800 or less, 700 or less, 600 or less, 500 or less, 400 or less, 300 or less, 200 or less, 100 or less, 80 or less, 70 or less, 50 or less, 30 or less, 20 or less, or 10 or less by the Etching defect evaluation method shown in Examples.

The solvent in the polymer solution is preferably a solvent used for polymerization of the polymer. Therefore, a polymer solution obtained by polymerizing a monomer in a solvent is preferably used as it is as a polymer solution for measuring the average particle size. Examples of the solvent used for polymerization of the polymer include polyhydric alcohol derivatives. Examples of the polyhydric alcohol derivatives include ethylene glycol monomethyl ether, ethylene glycol monomethyl ether acetate, propylene glycol monomethyl ether, and propylene glycol monomethyl ether acetate.

From the viewpoint of measurement reliability, the concentration of the polymer in the polymer solution is preferably 10 to 30% by mass. In the case of a polymer solution having such a concentration, entanglement between polymer chains occurs to some extent in the polymer solution, and a result correlated with generation of fine particulate etching residues is more easily obtained.

Usually, since the amount of the polymer in the composition for forming a resist underlayer film is small, even when an attempt is made to measure the average particle size of the polymer using the composition for forming a resist underlayer film, it is difficult to obtain a result correlated with the generation of fine particulate etching residues. The reason for this is considered to be that when the concentration of the polymer is low, entanglement between polymer chains is less likely to occur. In addition, the composition for forming a resist underlayer film as a product may also contain components other than the polymer (for example, a crosslinking agent, a curing catalyst, and other components), and when the dynamic light scattering measurement is performed on the composition for forming a resist underlayer film, the particle size distribution of the polymer and the particle size distribution of the components other than the polymer are mixed in the obtained particle size distribution, and it is difficult to obtain a result correlated with the generation of fine particulate etching residues.

From such a viewpoint, when the average particle size is measured in the present invention, it is suitable to use a polymer solution, and it is more suitable to use a polymer solution having a polymer concentration of 10 to 30% by mass. Furthermore, it is suitable to use a polymer solution in which only a polymer is dissolved in a solvent without containing a crosslinking agent, a curing catalyst, or the like.

### <Polymer>

The polymer contains a repeating unit (1) represented by the following Formula (1). The polymer also has a repeating unit (2) other than the repeating unit (1). In this respect, the polymer can be said to be a copolymer.

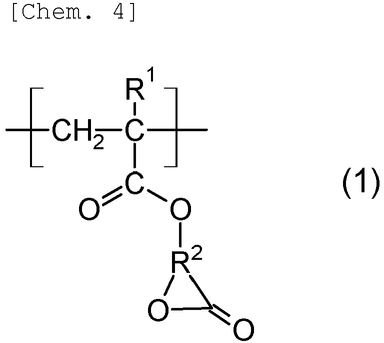

(In Formula (1), R¹ represents a hydrogen atom, a methyl group, or a halogen atom, and R² represents a trivalent hydrocarbon group having 3 to 6 carbon atoms. Here, the lactone structure containing R² is a 5-membered ring or a 6-membered ring.)

Examples of the halogen atom in the present specification include a fluorine atom, a chlorine atom, a bromine atom, and an iodine atom.

Examples of the repeating unit (1) represented by Formula (1) include repeating units represented by the following Formulas (1-1) to (1-3).

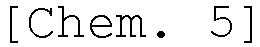

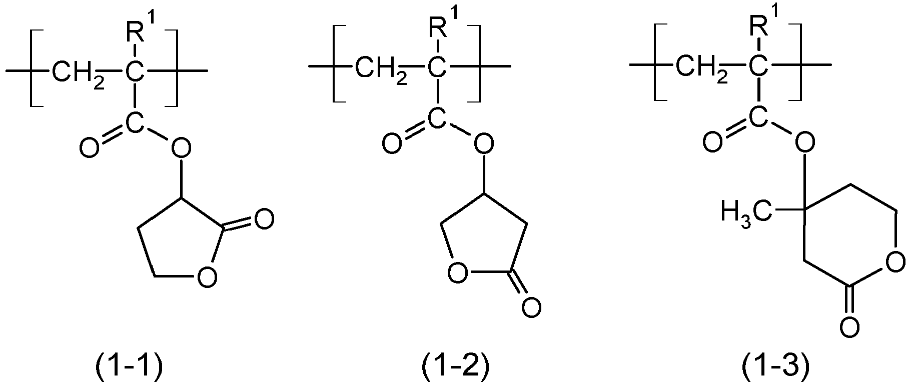

(In Formulas (1-1) to (1-3), R¹ represents a hydrogen atom, a methyl group, or a halogen atom.)

R¹ in Formula (1) and Formulas (1-1) to (1-3) is preferably a methyl group.

The repeating unit (2) is not particularly limited as long as the repeating unit (2) is a repeating unit other than the repeating unit (1) represented by Formula (1), but the repeating unit (2) preferably includes a repeating unit (2A) represented by the following Formula (2A).

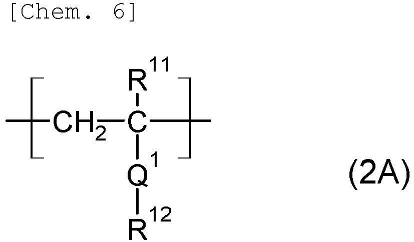

(In Formula (2A), R¹¹ represents a hydrogen atom, a methyl group, or a halogen atom, Q¹ represents a single bond or a divalent linking group, and R¹² represents a hydrogen atom or a monovalent organic group.)

The divalent linking group in Q¹ is not particularly limited, and examples thereof include -C(=O)O-, -O-, - C(=O)-N(-R)- (R represents a hydrogen atom or an alkyl group having 1 to 4 carbon atoms), -NHC(=O)NH- (urea bond), -NHC(=O)O- (urethane bond), -C (=O)-, -S-, -SO-, and -NH-.

The monovalent organic group in R¹² is not particularly limited, and examples thereof include a monovalent organic group having 1 to 30 carbon atoms.

Examples of the monovalent organic group in R¹² include a substituted or unsubstituted alkyl group having 1 to 10 carbon atoms, a substituted or unsubstituted aralkyl group, a substituted or unsubstituted carbocyclic aromatic group, and a substituted or unsubstituted heterocyclic aromatic group.

Examples of these substituents include a halogen atom, a hydroxy group, a carboxy group, an alkoxy group, a cyano group, a nitro group, and an amino group. Examples of the alkoxy group include an alkoxy group having 1 to 6 carbon atoms.

The "1 to 10 carbon atoms" in the "substituted or unsubstituted alkyl group having 1 to 10 carbon atoms" does not include the number of carbon atoms of the substituent.

Examples of the alkyl group in the substituted or unsubstituted alkyl group having 1 to 10 carbon atoms include a methyl group, an ethyl group, an n-propyl group, an i-propyl group, a cyclopropyl group, an n-butyl group, an i-butyl group, a s-butyl group, a t-butyl group, a cyclobutyl group, a 1-methyl-cyclopropyl group, a 2-methyl-cyclopropyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, a 2-ethyl-3-methyl-cyclopropyl group, a decyl group, an undecyl group, a dodecyl group, a tridecyl group, a tetradecyl group, a pentadecyl group, a hexadecyl group, a heptadecyl group, an octadecyl group, a nonadecyl group, and an icodecyl group.

Examples of the aralkyl group in the substituted or unsubstituted aralkyl group include a benzyl group, a phenethyl group, a naphthylmethyl group, and an anthrylmethyl group.

Examples of the carbocyclic aromatic group in the substituted or unsubstituted carbocyclic aromatic group include a phenyl group, a naphthyl group, an anthryl group, and a phenanthryl group.

The number of carbon atoms of the substituted or unsubstituted carbocyclic aromatic group is, for example, 6 to 30.

Examples of the substituted or unsubstituted carbocyclic aromatic group include a phenyl group, an o-methylphenyl group, an m-methylphenyl group, a p-methylphenyl group, an o-chlorophenyl group, an m-chlorophenyl group, a p-chlorophenyl group, an o-fluorophenyl group, a p-fluorophenyl group, an o-methoxyphenyl group, a p-methoxyphenyl group, a p-nitrophenyl group, a p-cyanophenyl group, an α-naphthyl group, a β-naphthyl group, an o-biphenylyl group, an m-biphenylyl group, a p-biphenylyl group, a 1-anthryl group, a 2-anthryl group, a 9-anthryl group, a 1-phenanthryl group, a 2-phenanthryl group, a 3-phenanthryl group, a 4-phenanthryl group, and a 9-phenanthryl group.

Examples of the heterocyclic aromatic group in the substituted or unsubstituted heterocyclic aromatic group include a pyridyl group, a quinolinyl group, and a quinoxalinyl group.

The repeating unit (2) preferably includes a repeating unit (2A-1) represented by the following Formula (2A-1) and a repeating unit (2A-2) represented by the following Formula (2A-2).

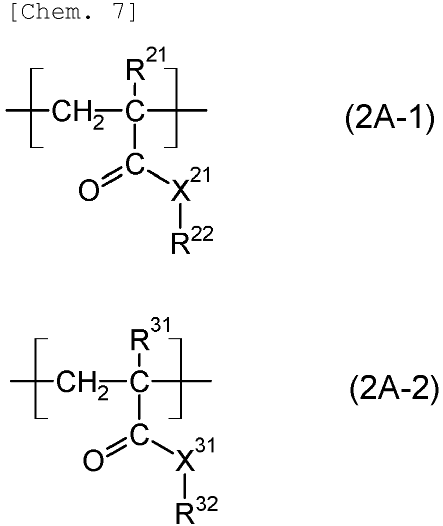

(In Formula (2A-1), X²¹ represents -O- or -N(-R)- (R represents a hydrogen atom or an alkyl group having 1 to 4 carbon atoms). R²¹ represents a hydrogen atom, a methyl group, or a halogen atom, and R²² represents a substituted or unsubstituted alkyl group having 1 to 10 carbon atoms.

In Formula (2A-2), X³¹ represents -O- or -N(-R)- (R represents a hydrogen atom or an alkyl group having 1 to 4 carbon atoms). R³¹ represents a hydrogen atom, a methyl group, or a halogen atom, and R³² represents a substituted or unsubstituted aralkyl group, a substituted or unsubstituted carbocyclic aromatic group, or a substituted or unsubstituted heterocyclic aromatic group.)

Specific examples of the substituted or unsubstituted alkyl group having 1 to 10 carbon atoms in R²² include specific examples of the substituted or unsubstituted alkyl group having 1 to 10 carbon atoms in the description of R12 .

Specific examples of the substituted or unsubstituted aralkyl group, the substituted or unsubstituted carbocyclic aromatic group, and the substituted or unsubstituted heterocyclic aromatic group in R³² include specific examples of the substituted or unsubstituted aralkyl group, the substituted or unsubstituted carbocyclic aromatic group, and the substituted or unsubstituted heterocyclic aromatic group in the description of R¹².

As R¹¹ in Formula (2A), R²¹ in Formula (2A-1), and R³¹ in Formula (2A-2), a methyl group is preferred.

The proportion of the repeating unit (1) in the polymer is not particularly limited.

The weight ratio of the repeating unit (1) to all repeating units in the polymer is preferably 1 to 75% by weight, more preferably 5 to 60% by weight, and particularly preferably 10 to 45% by weight.

The weight ratio of the repeating unit (2) to all repeating units in the polymer is not particularly limited, but is preferably 25 to 99% by weight, more preferably 40 to 95% by weight, and particularly preferably 55 to 90% by weight.

The total weight ratio of the repeating unit (2A-1) and the repeating unit (2A-2) to all repeating units in the polymer is not particularly limited, but is preferably 25 to 99% by weight, more preferably 40 to 95% by weight, and particularly preferably 55 to 90% by weight.

The molecular weight of the polymer is not particularly limited.

The weight average molecular weight of the polymer measured by gel permeation chromatography is not particularly limited, but is preferably 100,000 or less, more preferably 50,000 or less, and particularly preferably 30,000 or less.

The lower limit of the weight average molecular weight of the polymer is not particularly limited, but the weight average molecular weight is preferably 5,000 or more.

### <<Method for Manufacturing Polymer>>

The polymer is obtained by radical polymerization of two or more types of monomers.

One of the two or more types of monomers is a monomer represented by the following Formula (1').

The method for manufacturing a polymer is a manufacturing method in which the average particle size of a polymer in a polymer solution is reduced. Examples of such a manufacturing method include a method for manufacturing a polymer described in WO2012/053434. Specific examples thereof include polymerization methods (Z1) and (Z2) described in [0062] to [0066] of WO2012/053434. The contents of WO2012/053434 are incorporated herein to the same extent as all specified.

Specific examples of the method for manufacturing a polymer include the methods for manufacturing a polymer described in Reference Example B-3 and Example B-3 of WO2012/053434. Here, the monomer represented by the following Formula (1') in the present specification corresponds to the monomer m-1 represented by Formula (m-1) in Reference Example B-3 of WO2012/053434 A. The monomer represented by the following Formula (2A'-1) in the present specification corresponds to the monomer m-7 represented by Formula (m-7) in Reference Example B-3 of WO2012/053434. The monomer represented by the following Formula (2A'-2) in the present specification corresponds to the monomer m-6 represented by Formula (m-6) in Reference Example B-3 of WO2012/053434.

In Reference Example B-3 of WO2012/053434, the following polymerization was carried out for the design of the composition of the solution Uc to be used in the subsequent step.

In the polymerization, a dropping solution containing a monomer mixture, a solvent, and a polymerization initiator is added dropwise into the flask from a dropping funnel at a constant dropping rate over 4 hours, and a temperature of 80°C is further maintained for 3 hours. Then, after 7 hours from the start of dropwise addition of the dropping solution, the reaction is stopped by cooling to room temperature.

In Reference Example B-3, after 0.5, 1, 2, 3, 4, 5, 6, and 7 hours from the start of dropwise addition of the dropping solution, 0.5 g of the polymerization reaction solution in the flask was sampled, and quantification of the monomers m-1, m-6, and m-7 was performed. Thus, the mass of each monomer remaining in the flask at the time of each sampling is determined.

In Reference Example B-3, the content ratio of the monomer unit (polymer composition) in the polymer produced in each reaction time zone is determined.

In Reference Example B-3, the composition x₀:y₀:z₀ of Uc is determined.

Based on the result of Reference Example B-3, in Example B-3, after the main step of supplying Sa into the reactor in advance and adding Tb and the polymerization initiator solution dropwise, a post-step of dropping Uc is provided.

In the first composition of Sa supplied in advance into the reaction vessel in Example B-3, the composition ratio of the monomer m-1 having a high polymerization rate is smaller than the composition ratio of the monomer m-1 in the target composition. By doing so, in Example B-3, it is possible to avoid that the monomer m-1 is unevenly distributed in the polymer chain generated at the initial stage of polymerization to be more than the composition ratio in the target composition. By doing so, entanglement of polymer chains is reduced, and as a result, a polymer having a small average particle size in the polymer solution can be obtained.

The monomer that gives the repeating unit (1) represented by Formula (1) to the polymer is a monomer represented by the following Formula (1').

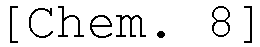

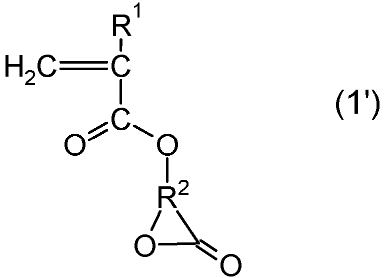

(In Formula (1'), R¹ and R² have the same meanings as R¹ and R² in Formula (1), respectively.)

The monomer that gives the repeating unit represented by Formula (1-1) to the polymer is a monomer represented by the following Formula (1'-1).

The monomer that gives the repeating unit represented by Formula (1-2) to the polymer is a monomer represented by the following Formula (1'-2).

The monomer that gives the repeating unit represented by Formula (1-3) to the polymer is a monomer represented by the following Formula (1'-3).

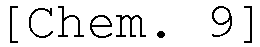

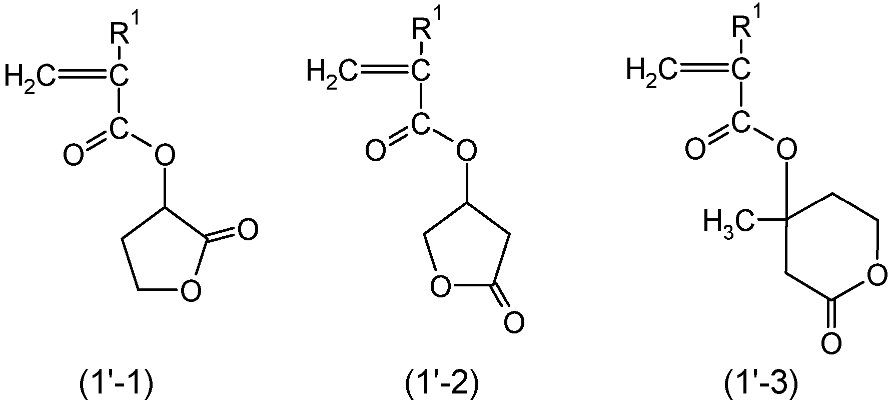

(In Formula (1'-1), R¹ has the same meaning as R¹ in Formula (1-1).)

(In Formula (1'-2), R¹ has the same meaning as R¹ in Formula (1-2).)

(In Formula (1'-3), R¹ has the same meaning as R¹ in Formula (1-3).)

The monomer that gives the repeating unit (2A) represented by Formula (2A) to the polymer is a monomer represented by the following Formula (2A').

The monomer that gives the repeating unit (2A-1) represented by Formula (2A-1) to the polymer is a monomer represented by the following Formula (2A'-1).

The monomer that gives the repeating unit (2A-2) represented by Formula (2A-2) to the polymer is a monomer represented by the following Formula (2A'-2).

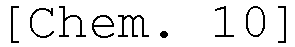

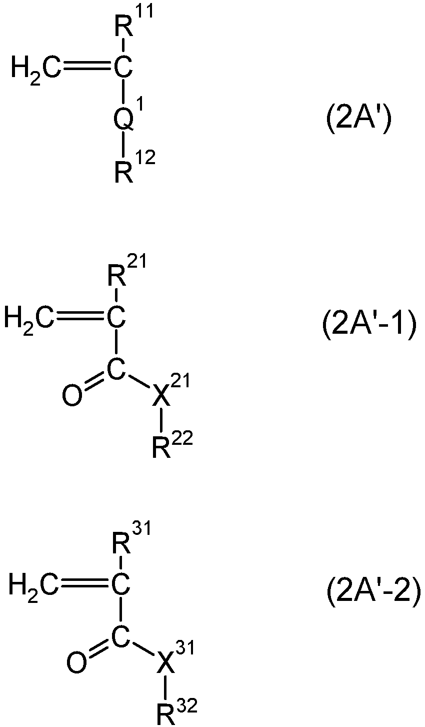

(In Formula (2A'), R¹¹, R¹², and Q¹ have the same meanings as R¹¹, R¹², and Q¹ in Formula (2A), respectively.

In Formula (2A'-1), R²¹, R²², and X²¹ have the same meanings as R²¹, R²², and X²¹ in Formula (2A-1), respectively.

In Formula (2A'-2), R³¹, R³², and X³¹ have the same meanings as R³¹, R³², and X³¹ in Formula (2A-2), respectively.)

Examples of the monomer represented by Formula (2A') include acrylic acid esters, methacrylic acid esters, acrylamides, methacrylamides, allyl compounds, vinyl ethers, vinyl esters, and styrene compounds.

Examples of the acrylic acid esters include substituted or unsubstituted alkyl acrylates with an alkyl group having 1 to 10 carbon atoms, aralkyl esters of acrylic acid, and aryl esters of acrylic acid.

Examples of the methacrylic acid esters include substituted or unsubstituted alkyl methacrylates with an alkyl group having 1 to 10 carbon atoms, aralkyl esters of methacrylic acid, and aryl esters of methacrylic acid.

Examples of the acrylamides include N-alkylacrylamide, N-arylacrylamide, N,N-dialkylacrylamide, N,N-diarylacrylamide, N-methyl-N-phenylacrylamide, and N-2-acetamidoethyl-N-acetylacrylamide.

Examples of the methacrylamides include N-alkyl methacrylamide, N-aryl methacrylamide, N,N-dialkyl methacrylamide, N,N-diaryl methacrylamide, N-methyl-N-phenyl methacrylamide, and N-ethyl-N-phenyl methacrylamide.

Examples of the vinyl ethers include alkyl vinyl ethers and vinyl aryl ethers.

Examples of the vinyl esters include vinyl butyrate, vinyl isobutyrate, and vinyl trimethyl acetate.

Examples of the styrenes include styrene, alkylstyrene, alkoxystyrene, halogenated styrene, and carboxystyrene.

### <<<Polymerization Initiator>>>

As the polymerization initiator used for the polymerization, an organic peroxide or a diazo-based compound can be used.

Examples of the organic peroxide include diacyl peroxides, peroxydicarbonates, peroxyesters, and sulfonates.

Examples of the diacyl peroxides include diacetyl peroxide, diisobutyl peroxide, didecanoyl peroxide, benzoyl peroxide, and succinic acid peroxide.

Examples of the peroxydicarbonates include diisopropyl peroxydicarbonate, di-2-ethylhexyl peroxydicarbonate, and diallyl peroxydicarbonate.

Examples of the peroxyesters include tert-butyl peroxyisobutyrate, tert-butyl neodecanoate, and cumene peroxyneodecanoate.

Examples of the sulfonates include acetylcyclohexylsulfonyl peroxide.

Examples of the diazo-based compound include 2,2'-azobisisobutyronitrile, 4,4'-azobis(4-cyanovaleric acid), 2,2'-azobis(4-methoxy-2,4-dimethoxyvaleronitrile), and 2,2'-azobis(2-cyclopropylpropionitrile).

When it is desired to terminate the polymerization in a short time, it is preferable to use a polymerization initiator having a decomposition half-life at 80°C of 10 hours or less. As such a polymerization initiator, benzoyl peroxide and 2,2'-azobisisobutyronitrile are preferable, and 2,2'-azobisisobutyronitrile is more preferable.

The amount of the polymerization initiator used is, for example, 0.0001 to 0.2 equivalents, and preferably 0.0005 to 0.1 equivalents, relative to the total amount of monomers used.

### <<<Solvent>>>

The solvent used for the polymerization is not particularly limited as long as the solvent is a solvent that is not involved in the polymerization reaction and is compatible with the obtained polymer, and examples thereof include aromatic hydrocarbons, alicyclic hydrocarbons, aliphatic hydrocarbons, ketones, ethers, esters, amides, sulfoxides, alcohols, and polyhydric alcohol derivatives.

Examples of the aromatic hydrocarbons include benzene, toluene, and xylene.

Examples of the alicyclic hydrocarbons include cyclohexane.

Examples of the aliphatic hydrocarbons include n-hexane and n-octane.

Examples of the ketones include acetone, methyl ethyl ketone, and cyclohexanone.

Examples of the ethers include tetrahydrofuran and dioxane.

Examples of the esters include ethyl acetate and butyl acetate.

Examples of the amides include N,N-dimethylformamide and N,N-dimethylacetamide.

Examples of the sulfoxides include dimethyl sulfoxide.

Examples of the alcohols include methanol and ethanol.

Examples of the polyhydric alcohol derivatives include ethylene glycol monomethyl ether, ethylene glycol monomethyl ether acetate, propylene glycol monomethyl ether, and propylene glycol monomethyl ether acetate.

These solvents can be used alone or in combination of two or more types thereof.

The polymerization temperature is not particularly limited as long as a side reaction such as a transfer reaction or a stop reaction does not occur and is in a temperature range in which the monomer is consumed and the polymerization is completed, but the polymerization is preferably performed in a temperature range of -100°C or higher and the solvent boiling point or lower.

The concentration of the monomer in the solvent is not particularly limited, but is usually 1 to 40% by mass and preferably 10 to 30% by weight.

The time for the polymerization reaction can be appropriately selected, but is usually in the range of 2 hours to 50 hours.

The content of the polymer in the composition for forming a resist underlayer film is not particularly limited, but is preferably 30% by mass to 95% by mass, more preferably 50% by mass to 90% by mass, and particularly preferably 60% by mass to 85% by mass with respect to the film forming component.

The film forming component is a component obtained by removing a volatile component (solvent) from the composition for forming a resist film.

### <Crosslinking Agent>

The composition for forming a resist underlayer film preferably contains a crosslinking agent.

The crosslinking agent contained as an optional component in the composition for forming a resist underlayer film has, for example, a functional group that reacts alone.

Examples of the crosslinking agent include hexamethoxymethylmelamine, tetramethoxymethylbenzoguanamine, 1,3,4,6-tetrakis(methoxymethyl)glycoluril(tetramethoxymethyl glycoluril) (POWDERLINK [registered trademark] 1174), 1,3,4,6-tetrakis(butoxymethyl)glycoluril, 1,3,4,6-tetrakis(hydroxymethyl)glycoluril, 1,3-bis(hydroxymethyl)urea, 1,1,3,3-tetrakis(butoxymethyl)urea, and 1,1,3,3-tetrakis(methoxymethyl)urea.

In addition, the crosslinking agent may be a nitrogen-containing compound having 2 to 6 substituents, which are represented by the following Formula (1d) and bonded to a nitrogen atom, in one molecule, which is described in WO2017/187969 A.

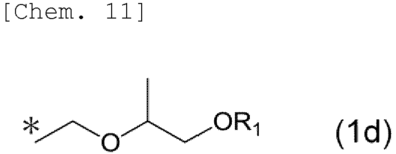

(In Formula (1d), R₁ represents a methyl group or an ethyl group. * represents a bonding site bonded to a nitrogen atom.)

The nitrogen-containing compound having 2 to 6 substituents represented by Formula (1d) in one molecule may be a glycoluril derivative represented by the following Formula (1E).

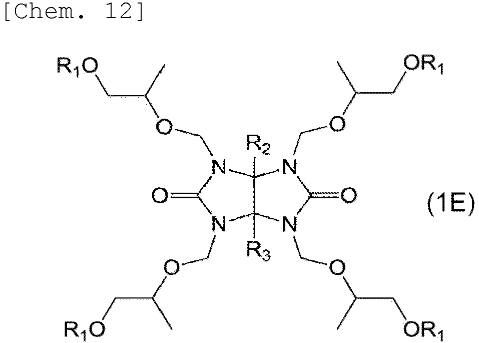

(In Formula (1E), four R₁ each independently represent a methyl group or an ethyl group, and R₂ and R₃ each independently represent a hydrogen atom, an alkyl group having 1 to 4 carbon atoms, or a phenyl group.)

Examples of the glycoluril derivative represented by the Formula (1E) include compounds represented by the following Formulas (1E-1) to (1E-6).

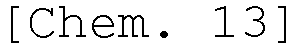

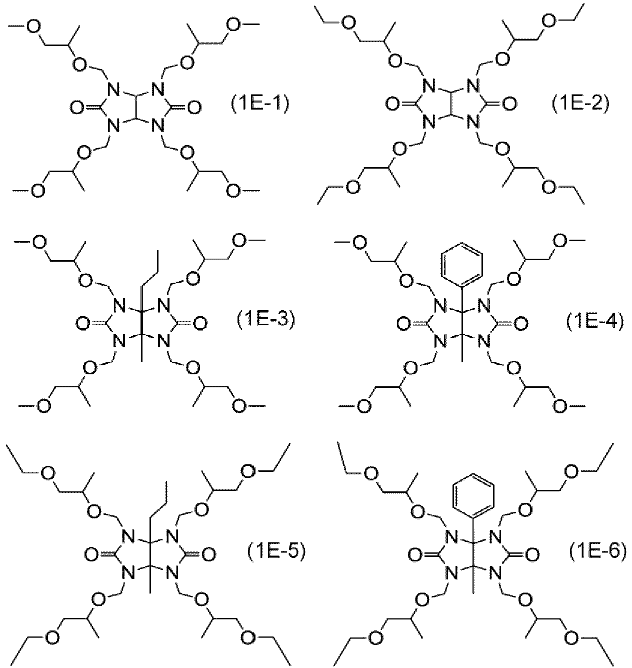

The nitrogen-containing compound having 2 to 6 substituents represented by the Formula (1d) in one molecule is obtained by reacting a nitrogen-containing compound having 2 to 6 substituents, which are represented by the following Formula (2d) and bonded to a nitrogen atom, in one molecule with at least one compound represented by the following Formula (3d).

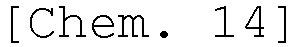

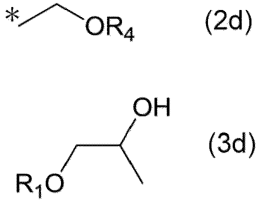

(In Formula (2d) and Formula (3d), R₁ represents a methyl group or an ethyl group, and R₄ represents an alkyl group having 1 to 4 carbon atoms. * represents a bonding site bonded to a nitrogen atom.)

The glycoluril derivative represented by the Formula (1E) is obtained by reacting a glycoluril derivative represented by the following Formula (2E) with at least one compound represented by the Formula (3d).

The nitrogen-containing compound having 2 to 6 substituents represented by the Formula (2d) in one molecule is, for example, a glycoluril derivative represented by the following Formula (2E).

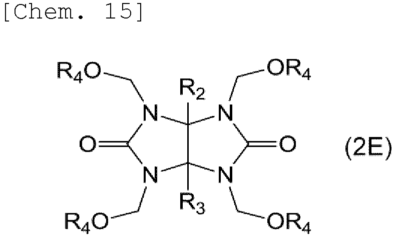

(In Formula (2E), R₂ and R₃ each independently represent a hydrogen atom, an alkyl group having 1 to 4 carbon atoms, or a phenyl group, and R₄ each independently represents an alkyl group having 1 to 4 carbon atoms.)

Examples of the glycoluril derivative represented by the Formula (2E) include compounds represented by the following Formulas (2E-1) to (2E-4). Furthermore, examples of the compound represented by the Formula (3d) include compounds represented by the following Formulas (3d-1) and (3d-2).

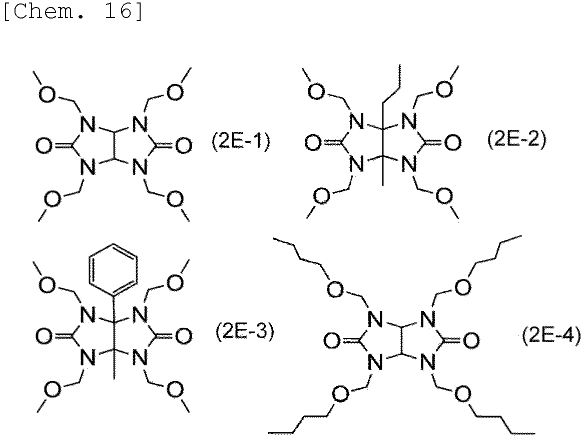

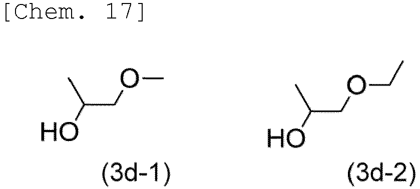

For the content related to the nitrogen-containing compound having 2 to 6 substituents, which are represented by Formula (1d) and bonded to a nitrogen atom, in one molecule, the entire disclosure of WO2017/187969 is incorporated in the present application.

The above crosslinking agent may be a crosslinkable compound represented by the following Formula (G-1) or (G-2) described in WO2014/208542.

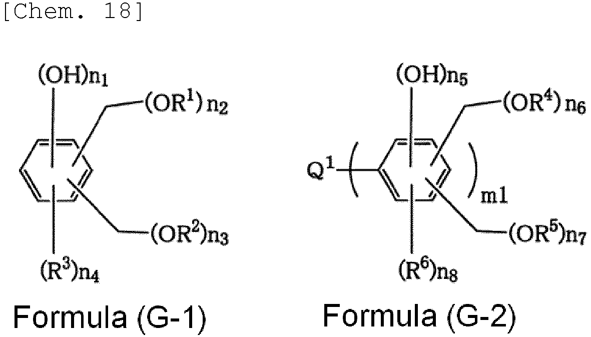

(In the formula, Q¹ represents a single bond or an m1-valent organic group, R¹ and R⁴ each represent an alkyl group having 2 to 10 carbon atoms or an alkyl group having 2 to 10 carbon atoms having an alkoxy group having 1 to 10 carbon atoms, R² and R⁵ each represent a hydrogen atom or a methyl group, and R³ and R⁶ each represent an alkyl group having 1 to 10 carbon atoms or an aryl group having 6 to 40 carbon atoms.

n1 represents an integer of 1 ≤ n1 ≤ 3, n2 represents an integer of 2 ≤ n2 ≤ 5, n3 represents an integer of 0 ≤ n3 ≤ 3, and n4 represents an integer of 0 ≤ n4 ≤ 3, with an integer of 3 ≤ (n1 + n2 + n3 + n4) ≤ 6.

n5 represents an integer of 1 ≤ n5 ≤ 3, n6 represents an integer of 1 ≤ n6 ≤ 4, n7 represents an integer of 0 ≤ n7 ≤ 3, and n8 represents an integer of 0 ≤ n8 ≤ 3, with an integer of 2 ≤ (n5 + n6 + n7 + n8) ≤ 5.

m1 represents an integer of 2 to 10.)

The crosslinkable compound represented by above-described Formula (G-1) or (G-2) may be obtained by reaction of a compound represented by the following Formula (G-3) or (G-4) with a hydroxyl group-containing ether compound or an alcohol having 2 to 10 carbon atoms.

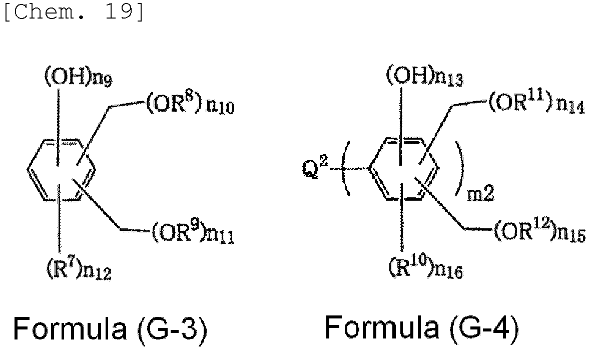

(In the formula, Q² represents a single bond or an m2-valent organic group. R⁸, R⁹, R¹¹, and R¹² each represent a hydrogen atom or a methyl group, and R⁷ and R¹⁰ each represent an alkyl group having 1 to 10 carbon atoms or an aryl group having 6 to 40 carbon atoms.

n9 represents an integer of 1 ≤ n9 ≤ 3, n10 represents an integer of 2 ≤ n10 ≤ 5, n11 represents an integer of 0 ≤ n11 ≤ 3, and n12 represents an integer of 0 ≤ n12 ≤ 3, with an integer of 3 ≤ (n9 + n10 + n11 + n12) ≤ 6.

n13 represents an integer of 1 ≤ n13 ≤ 3, n14 represents an integer of 1 ≤ n14 ≤ 4, n15 represents an integer of 0 ≤ n15 ≤ 3, and n16 represents an integer of 0 ≤ n16 ≤ 3, with an integer of 2 ≤ (n13 + n14 + n15 + n16) ≤ 5.

m2 represents an integer of 2 to 10.)

The compounds represented by the above-described Formulas (G-1) and (G-2) can be exemplified below.

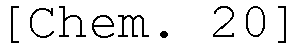

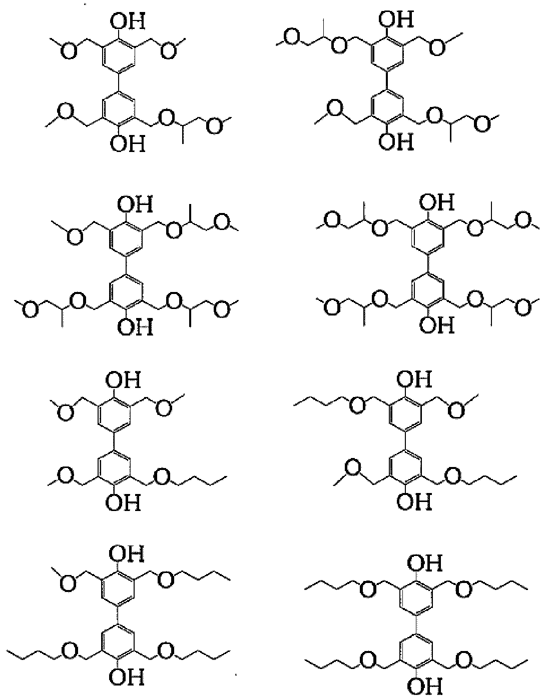

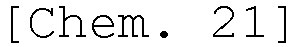

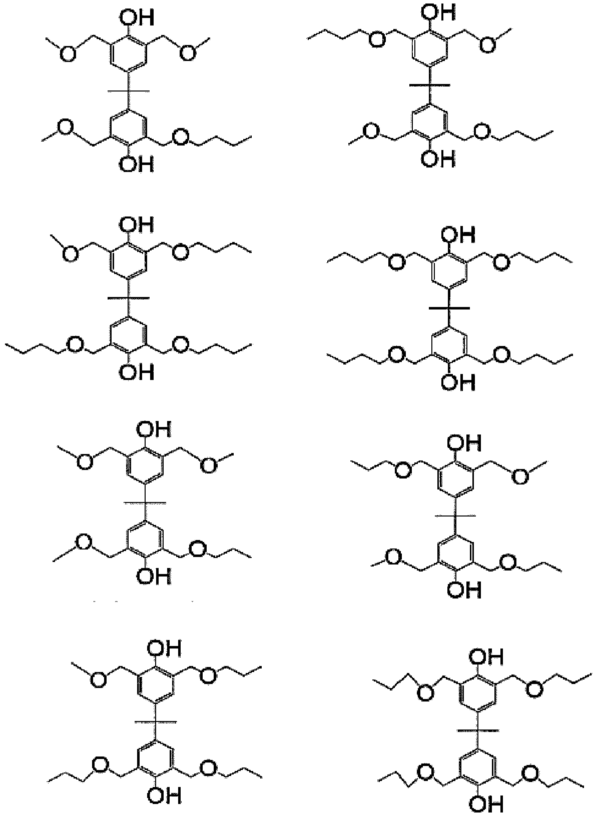

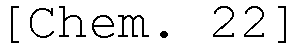

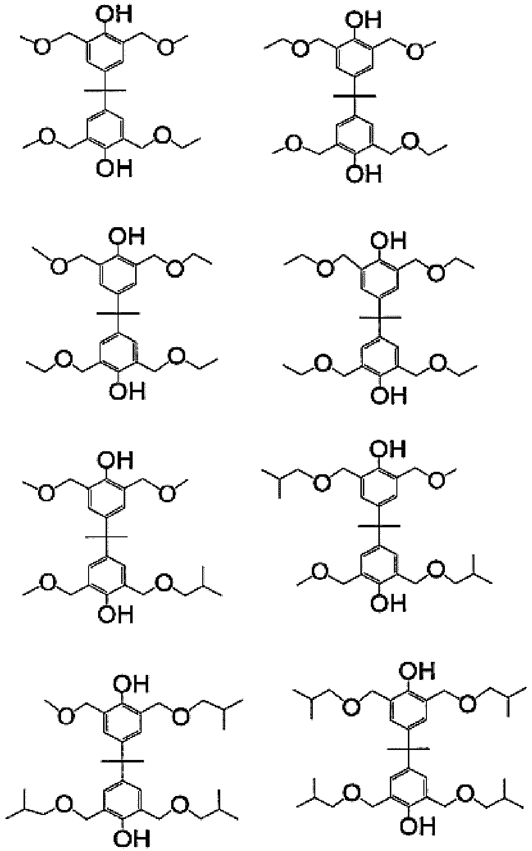

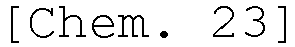

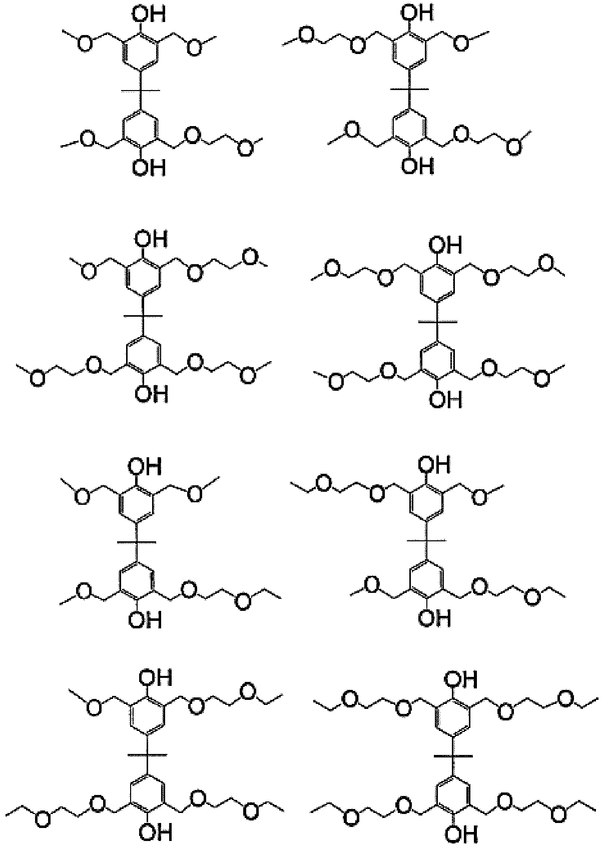

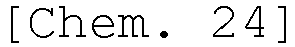

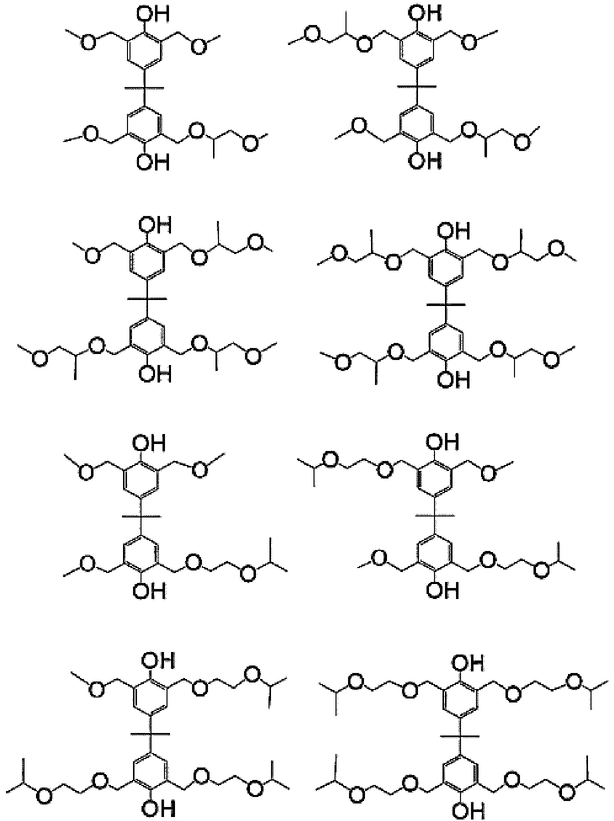

The compounds represented by Formulas (G-3) and (G-4) can be exemplified below.

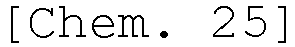

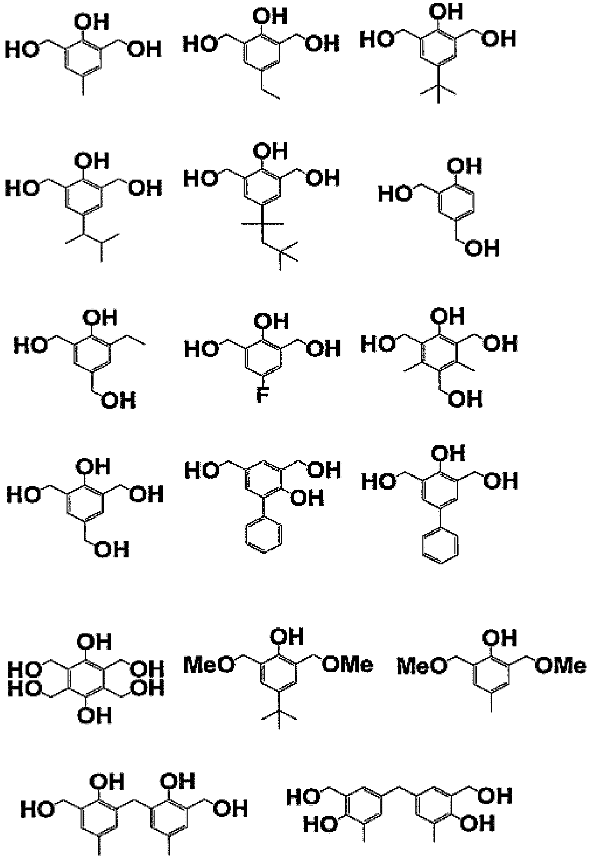

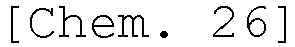

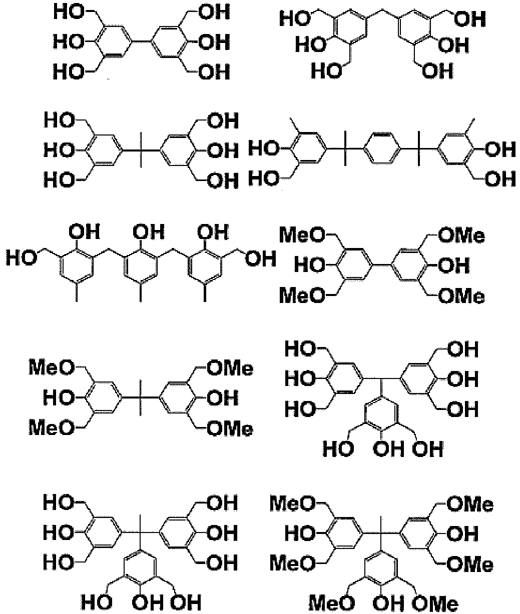

In the formula, Me represents a methyl group.

The entire disclosure of WO2014/208542 is incorporated herein by reference.

When the crosslinking agent is used, the content ratio of the crosslinking agent in the composition for forming a resist underlayer film is, for example, 1% by mass to 50% by mass, and preferably 5% by mass to 40% by mass with respect to the polymer.

### <Curing Catalyst>

As the curing catalyst contained as an optional component in the composition for forming a resist underlayer film, both a thermal acid generator and a photoacid generator can be used, but it is preferable to use a thermal acid generator.

Examples of the thermal acid generator include sulfonic acid compounds and carboxylic acid compounds such as p-toluenesulfonic acid, trifluoromethanesulfonic acid, pyridinium-p-toluenesulfonate(pyridinium-p-toluenesulfonic acid), pyridinium phenol sulfonic acid, pyridinium-p-hydroxybenzenesulfonic acid (p-phenolsulfonic acid pyridinium salt), pyridinium-trifluoromethanesulfonic acid, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, and hydroxybenzoic acid.

Examples of the photoacid generator include an onium salt compound, a sulfonimide compound, and a disulfonyl diazomethane compound.

Examples of the onium salt compound include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate; and sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compound include N-(trifluoromethanesulfonyloxy) succinimide, N-(nonafluoronormalbutanesulfonyloxy)succinimide, N-(camphorsulfonyloxy)succinimide, and N-(trifluoromethanesulfonyloxy)naphthalimide.

Examples of the disulfonyl diazomethane compound include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

Only one type of curing catalyst can be used, or two or more types thereof can be used in combination.

When a curing catalyst is used, the content ratio of the curing catalyst is, for example, 0.1% by mass to 50% by mass, and preferably 1% by mass to 30% by mass with respect to the crosslinking agent.

### <Solvent>

As the solvent, an organic solvent generally used for a chemical solution for a semiconductor lithography process is preferable. Specifically, examples thereof include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether, propylene glycol monoethyl ether, propylene glycol monomethyl ether acetate, propylene glycol propyl ether acetate, toluene, xylene, methyl ethyl ketone, methyl isobutyl ketone, cyclopentanone, cyclohexanone, cycloheptanone, 4-methyl-2 pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxy cyclopentane, anisole, γ-butyrolactone, N-methylpyrrolidone, N,N-dimethylformamide, and N,N-dimethylacetamide. These solvents can be used alone or in combination of two or more types thereof.

Among these solvents, propylene glycol monomethyl ether, propylene glycol monomethyl ether acetate, ethyl lactate, butyl lactate, and cyclohexanone are preferable. In particular, propylene glycol monomethyl ether and propylene glycol monomethyl ether acetate are preferable.

### <Other Components>

In the composition for forming a resist underlayer film, a surfactant can be further added in order to further improve the coating property for surface unevenness without generating pinholes, striations, and the like.

Examples of the surfactant include nonionic surfactants such as polyoxyethylene alkyl ethers (for example, polyoxyethylene lauryl ether, polyoxyethylene stearyl ether, polyoxyethylene cetyl ether, and polyoxyethylene oleyl ether), polyoxyethylene alkyl allyl ethers (for example, polyoxyethylene octylphenol ether and polyoxyethylene nonylphenol ether), polyoxyethylene/polyoxypropylene block copolymers, sorbitan fatty acid esters (for example, sorbitan monolaurate, sorbitan monopalmitate, sorbitan monostearate, sorbitan monooleate, sorbitan trioleate, and sorbitan tristearate), polyoxyethylene sorbitan fatty acid esters (for example, polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate); fluorinated surfactants such as F-top EF301, EF303, and EF352 (manufactured by TOHKEM PRODUCTS Corporation, product name), Megaface F171, F173, and R-30 (manufactured by DIC Corporation, product name), Fluorad FC430 and FC431 (Sumitomo 3M Co., Ltd., product name), AsahiGuard AG710, and Surflon S-382, SC101, SC102, SC103, SC104, SC105, and SC106 (manufactured by Asahi Glass Co., Ltd., product name); and organosiloxane polymer KP341 (manufactured by Shin-Etsu Chemical Co., Ltd.)

The blending amount of these surfactants is not particularly limited, but is usually 2.0% by mass or less, and preferably 1.0% by mass or less with respect to the total solid content of the composition for forming a resist underlayer film.

These surfactants may be added alone, or may be added in combination of two or more thereof.

The film forming component contained in the composition for forming a resist underlayer film, that is, the component excluding the solvent is, for example, 0.01% by mass to 10% by mass of the composition for forming a resist underlayer film.

### (Resist Underlayer Film)

The resist underlayer film of the present invention is a cured product of the composition for forming a resist underlayer film described above.

The resist underlayer film can be manufactured, for example, by coating a semiconductor substrate with the above-described composition for forming a resist underlayer film and baking the composition.

Examples of the semiconductor substrate coated with the composition for forming a resist underlayer film include silicon wafers, germanium wafers, and compound semiconductor wafers such as gallium arsenide, indium phosphide, gallium nitride, indium nitride, and aluminum nitride.

When a semiconductor substrate having an inorganic film formed on a surface thereof is used, the inorganic film is formed by, for example, an atomic layer deposition (ALD) method, a chemical vapor deposition (CVD) method, a reactive sputtering method, an ion plating method, a vacuum deposition method, or a spin coating method (spin on glass: SOG). Examples of the inorganic film include a polysilicon film, a silicon oxide film, a silicon nitride film, a boro-phospho silicate glass (BPSG) film, a titanium nitride film, a titanium nitride oxide film, a tungsten film, a gallium nitride film, and a gallium arsenide film. The inorganic film may be a single layer or a multilayer of two or more layers. In the case of multiple layers or more, each layer may be the same type of inorganic film or different types of inorganic films.

The thickness of the inorganic film is not particularly limited.

Such a semiconductor substrate is coated with the composition for forming a resist underlayer film of the present invention by an appropriate coating method such as a spinner or a coater. Thereafter, baking is performed using heating means such as a hot plate to form a resist underlayer film. The baking conditions are appropriately selected from a baking temperature of 100°C to 400°C and a baking time of 0.3 minutes to 60 minutes. Preferably, the baking temperature is 120°C to 350°C and the baking time is 0.5 minutes to 30 minutes, and more preferably, the baking temperature is 150°C to 300°C and the baking time is 0.8 minutes to 10 minutes.

The lower limit of the film thickness of the resist underlayer film is, for example, 1 nm, 2 nm, 3 nm, 5 nm, 10 nm, 20 nm, 30 nm, 40 nm, 50 nm, 70 nm, 80 nm, 90 nm, or 100 nm, and the upper limit is, for example, 10 um, 8 um, 5 um, 3 um, 2 um, 1 µm, 900 nm, 800 nm, 700 nm, 600 nm, 500 nm, 400 nm, 300 nm, or 200 nm.

The method of measuring the film thickness of the resist underlayer film in the present specification is as follows.
. Name of measuring apparatus: Ellipse type film thickness measuring apparatus RE-3100 (SCREEN Holdings Co., Ltd.)
· SWE (Single Wavelength Ellipsometer) Mode
· Arithmetic average of 8 points (for example, 8 points are measured at intervals of 1 cm in the wafer X direction.)

### (Semiconductor Processing Substrate)

A semiconductor processing substrate of the present invention includes a semiconductor substrate and a resist underlayer film of the present invention.

Examples of the semiconductor substrate include the above-described semiconductor substrate.

The resist underlayer film is disposed, for example, on a semiconductor substrate.

### (Method for Manufacturing Semiconductor Element, and Pattern Forming Method)

The method for manufacturing a semiconductor element of the present invention includes at least the following steps:
• a step of forming a resist underlayer film on a semiconductor substrate using the composition for forming a resist underlayer film of the present invention; and
• a step of forming a resist film on the resist underlayer film.

The pattern forming method of the present invention includes at least the following steps:
• a step of forming a resist underlayer film on a semiconductor substrate using the composition for forming a resist underlayer film of the present invention;
• a step of forming a resist film on the resist underlayer film;
• a step of irradiating the resist film with light or electron beam, and then developing the resist film to obtain a resist pattern; and
• a step of etching a resist underlayer film using the resist pattern as a mask.

Usually, a resist film is formed on the resist underlayer film.

The film thickness of the resist film is preferably 200 nm or less, more preferably 150 nm or less, still more preferably 100 nm or less, and particularly preferably 80 nm or less. Further, the film thickness of the resist film is preferably 10 nm or more, more preferably 20 nm or more, and particularly preferably 30 nm or more.

The resist formed on the resist underlayer film, for example, by coating and baking by a known method is not particularly limited as long as the resist responds to the light or electron beam (EB) used for irradiation. Both a negative photoresist and a positive photoresist can be used.

The light or electron beam is not particularly limited, and examples thereof include i-ray (365 nm), KrF excimer laser (248 nm), ArF excimer laser (193 nm), and EUV (extreme ultraviolet ray; 13.5 nm) and EB (electron beam).

In the present specification, a resist responding to EB is also referred to as a photoresist.

Examples of the photoresist include a positive photoresist composed of a novolak resin and 1,2-naphthoquinone diazide sulfonic acid ester; a chemically amplified photoresist composed of a photoacid generator and a binder having a group which is decomposed by an acid to increase the alkali dissolution rate; a chemically amplified photoresist composed of a low molecular compound which is decomposed by an acid to increase the alkali dissolution rate of the photoresist, an alkali-soluble binder, and a photoacid generator; a chemically amplified photoresist composed of a binder that has a group which is decomposed by an acid to increase the alkali dissolution rate, a low molecular compound which is decomposed by an acid to increase the alkali dissolution rate of the photoresist, and a photoacid generator; and a resist containing metal elements. Examples thereof include product name V146G manufactured by JSR Corporation, product name APEX-E manufactured by Shipley, product name PAR710 manufactured by Sumitomo Chemical Co., Ltd., and product names AR2772 and SEPR430 manufactured by Shin-Etsu Chemical Co., Ltd. Further, examples thereof include a fluorine-containing atomic polymer-based photoresist as described in Proc. SPIE, Vol. 3999, 330-334 (2000), Proc. SPIE, Vol. 3999, 357-364 (2000), or Proc. SPIE, Vol. 3999, 365-374 (2000).

In addition, so-called resist compositions such as resist compositions described in WO2019/188595, WO2019/187881, WO2019/187803, WO2019/167737, WO2019/167725, WO2019/187445, WO2019/167419, WO2019/123842, WO2019/054282, WO2019/058945, WO2019/058890, WO2019/039290, WO2019/044259, WO2019/044231, WO2019/026549, WO2018/193954, WO2019/172054, WO2019/021975, WO2018/230334, WO2018/194123, JP 2018-180525 A, WO2018/190088, JP 2018-070596, JP 2018-028090 A, JP 2016-153409 A, JP 2016-130240 A, JP 2016-108325 A, JP 2016-047920 A, JP 2016-035570 A, JP 2016-035567 A, JP 2016-035565 A, JP 2019-101417 A, JP 2019-117373 A, JP 2019-052294 A, JP 2019-008280 A, JP 2019-008279 A, JP 2019-003176 A, JP 2019-003175 A, JP 2018-197853 A, JP 2019-191298 A, JP 2019-061217 A, JP 2018-045152 A, JP 2018-022039 A, JP 2016-090441 A, JP 2015-10878 A, JP 2012-168279 A, JP 2012-022261 A, JP 2012-022258 A, JP 2011-043749 A, JP 2010-181857 A, JP 2010-128369 A, WO2018/031896, JP 2019-113855, WO2017/156388, WO2017/066319, JP 2018-41099 A, WO2016/065120, WO2015/026482, JP 2016-29498 A, and JP 2011-253185 A, radiation-sensitive resin compositions, high-resolution patterning compositions based on organometallic solutions, and metal-containing resist compositions can be used, but are not limited to these.

Examples of the resist composition include the following compositions.

A photosensitive or radiation-sensitive resin composition containing: a resin A having a repeating unit having an acid-decomposable group in which a polar group is protected by a protecting group that is removed by the action of an acid; and a compound represented by the following general Formula (21).

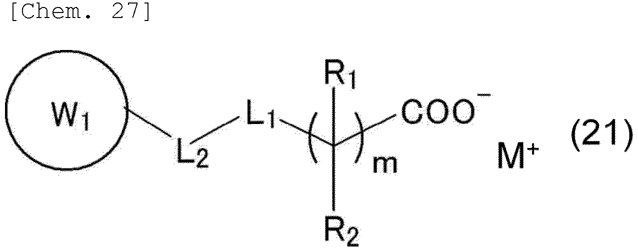

In the general Formula (21), m represents an integer of 1 to 6.

R₁ and R₂ each independently represent a fluorine atom or a perfluoroalkyl group.

L₁ represents -O-, -S-, -COO-, -SO₂-, or -SO₃-.

L₂ represents an alkylene group optionally having a substituent or a single bond.

W₁ represents a cyclic organic group which may have a substituent.

M⁺ represents a cation.

A metal-containing film forming composition for extreme ultraviolet ray or electron beam lithography, containing: a compound having a metal-oxygen covalent bond; and a solvent, in which metal elements constituting the above compound belong to the third to seventh periods of Groups 3 to 15 of the periodic table.

A radiation-sensitive resin composition containing: a polymer having a first structural unit represented by the following Formula (31) and a second structural unit represented by the following Formula (32) and containing an acid-dissociable group; and an acid generator.

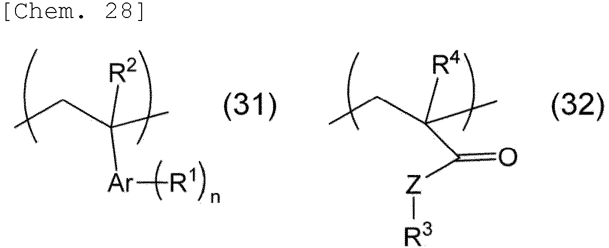

(In Formula (31), Ar is a group obtained by removing (n + 1) hydrogen atoms from an arene having 6 to 20 carbon atoms. R₁ is a hydroxy group, a sulfanyl group, or a monovalent organic group having 1 to 20 carbon atoms. n is an integer of 0 to 11. When n is 2 or more, a plurality of R₁ are the same or different. R₂ is a hydrogen atom, a fluorine atom, a methyl group, or a trifluoromethyl group. In Formula (32), R³ is a monovalent group having 1 to 20 carbon atoms and containing the above acid-dissociable group. Z is a single bond, an oxygen atom or a sulfur atom. R⁴ is a hydrogen atom, a fluorine atom, a methyl group, or a trifluoromethyl group.

A resist composition containing: a resin (A1) containing a structural unit having a cyclic carbonate structure, a structural unit represented by the following formula, and a structural unit having an acid-unstable group; and an acid generator.

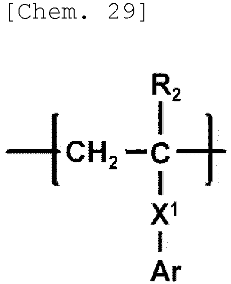

[In the formula,
R₂ represents an alkyl group having 1 to 6 carbon atoms optionally having a halogen atom, a hydrogen atom, or a halogen atom, X¹ represents a single bond, -CO-O-*, or -CO-NR⁴-*, * represents a bonding site with -Ar, R⁴ represents a hydrogen atom or an alkyl group having 1 to 4 carbon atoms, and Ar represents an aromatic hydrocarbon group having 6 to 20 carbon atoms which may have one or more groups selected from the group consisting of a hydroxy group and a carboxyl group.]

Examples of the resist film include the following.

A resist film containing: a base resin containing a repeating unit represented by the following Formula (a1) and/or a repeating unit represented by the following Formula (a2); and a repeating unit that generates an acid bonded to a polymer main chain by exposure.

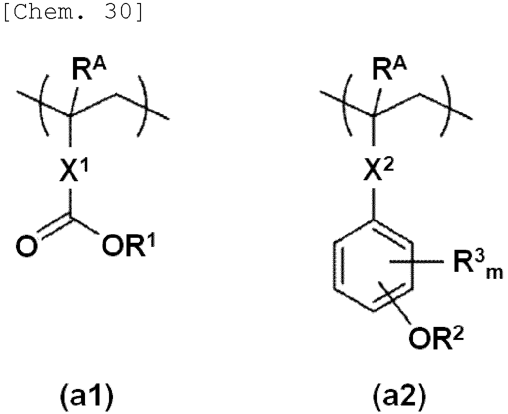

(In Formula (a1) and Formula (a2), R^{A} are each independently a hydrogen atom or a methyl group. R₁ and R₂ are each independently a tertiary alkyl group having 4 to 6 carbon atoms. R³ is each independently a fluorine atom or a methyl group. m is an integer of 0 to 4. X¹ is a single bond, a phenylene group or a naphthylene group, or a linking group having 1 to 12 carbon atoms containing at least one selected from an ester bond, a lactone ring, a phenylene group, and a naphthylene group. X² is a single bond, an ester bond, or an amide bond.)

Examples of the resist material include the following.

A resist material containing a polymer having a repeating unit represented by the following Formula (b1) or Formula (b2).

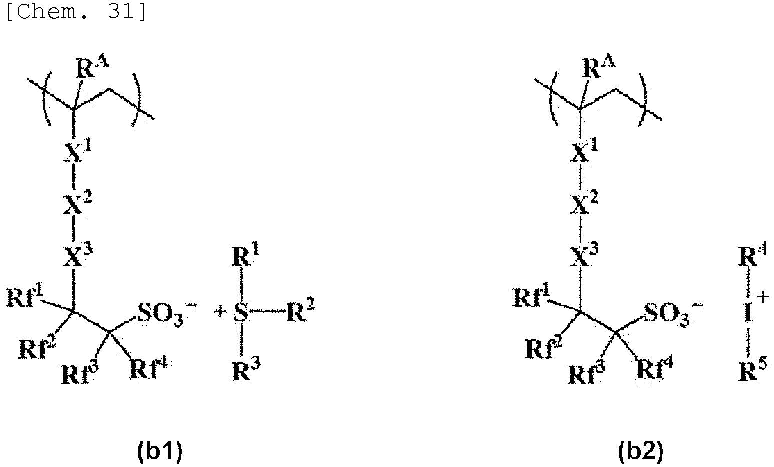

(In Formula (b1) and Formula (b2), R^{A} is a hydrogen atom or a methyl group. X¹ is a single bond or an ester group. X² is a linear, branched, or cyclic alkylene group having 1 to 12 carbon atoms or an arylene group having 6 to 10 carbon atoms, and a part of the methylene group constituting the alkylene group may be substituted with an ether group, an ester group, or a lactone ring-containing group, and at least one hydrogen atom contained in X² is substituted with a bromine atom. X³ is a single bond, an ether group, an ester group, or a linear, branched, or cyclic alkylene group having 1 to 12 carbon atoms, and a part of the methylene group constituting the alkylene group may be substituted with an ether group or an ester group. Rf¹ to Rf⁴ are each independently a hydrogen atom, a fluorine atom, or a trifluoromethyl group, and at least one of Rf¹ to Rf⁴ is a fluorine atom or a trifluoromethyl group. In addition, Rf¹ and Rf² may be combined to form a carbonyl group. R₁ to R⁵ are each independently a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, some or all of hydrogen atoms of these groups may be substituted with a hydroxy group, a carboxy group, a halogen atom, an oxo group, a cyano group, an amide group, a nitro group, a sultone group, a sulfone group, or a sulfonium salt-containing group, and some of methylene groups constituting these groups may be substituted with an ether group, an ester group, a carbonyl group, a carbonate group, or a sulfonic acid ester group. R₁ and R₂ may be bonded to each other to form a ring together with the sulfur atom to which R₁ and R₂ are bonded.)

A resist material containing a base resin containing a polymer containing a repeating unit represented by the following Formula (a).

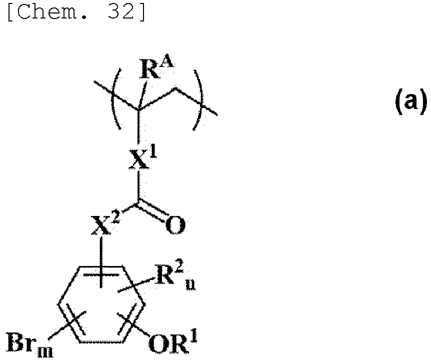

(In Formula (a), R^{A} is a hydrogen atom or a methyl group. R₁ is a hydrogen atom or an acid-unstable group. R₂ is a linear, branched, or cyclic alkyl group having 1 to 6 carbon atoms or a halogen atom other than bromine. X¹ is a single bond or a phenylene group, or a linear, branched, or cyclic alkylene group having 1 to 12 carbon atoms which may contain an ester group or a lactone ring. X² is -O-, -O-CH₂-, or -NH-. m is an integer of 1 to 4. u is an integer of 0 to 3. Here, m + u is an integer of 1 to 4.)

A resist composition which generates an acid by exposure and of which solubility in a developer is changed by an action of the acid, the resist composition containing:
a base material component (A) of which solubility in a developer is changed by an action of an acid and a fluorine additive component (F) which exhibits decomposability in an alkaline developer, in which
the fluorine additive component (F) contains a fluororesin component (F1) having a constituent unit (f1) containing a base dissociable group and a constituent unit (f2) containing a group represented by the following general Formula (f2-(r-1)).

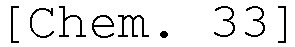

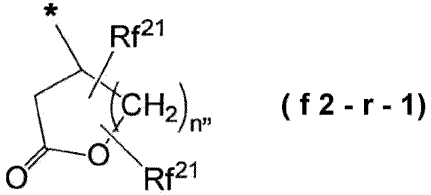

[In Formula (f2-(r-1)), Rf²¹ are each independently a hydrogen atom, an alkyl group, an alkoxy group, a hydroxyl group, a hydroxyalkyl group, or a cyano group. n" is an integer of 0 to 2. * is a bonding site.]

The constituent unit (f1) includes a constituent unit represented by the following general Formula (f1-1) or a constituent unit represented by the following general Formula (f1-2).

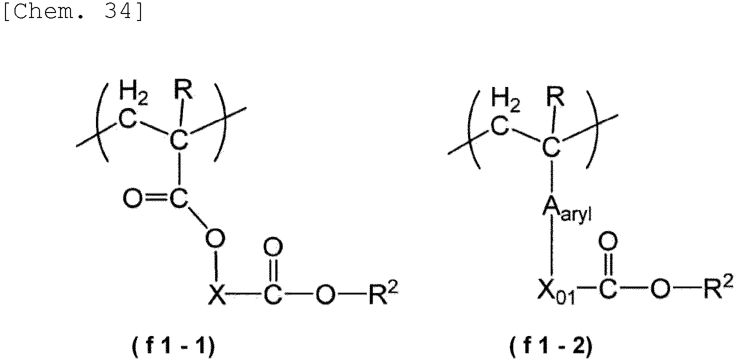

[In Formulas (f1-1) and (f1-2), R are each independently a hydrogen atom, an alkyl group having 1 to 5 carbon atoms, or a halogenated alkyl group having 1 to 5 carbon atoms. X is a divalent linking group having no acid-dissociable site. A_{aryl} is a divalent aromatic cyclic group which may have a substituent. X₀₁ is a single bond or a divalent linking group. R² are each independently an organic group having a fluorine atom.]

Examples of the coating, the coating solution, and the coating composition include the following.

A coating containing a metal oxo-hydroxo network having organic ligands via metal carbon bonds and/or metal carboxylate bonds.

An inorganic oxo-hydroxo-based composition.

A coating solution containing: an organic solvent; a first organometallic composition represented by the Formula R_{z}SnO_{(2-(z/2)-(x/2))}(OH)ₓ (where 0 < z ≤ 2 and 0 < (z + x) ≤ 4), the formula R'ₙSnX₄₋ₙ (where n = 1 or 2), or mixtures thereof, in which R and R' are independently hydrocarbyl groups having 1 to 31 carbon atoms, and X is a ligand having a hydrolysable bond to Sn or a combination thereof; and a hydrolyzable metal compound represented by the Formula MX'ᵥ (where M is a metal selected from the group 2 to 16 of the periodic table of elements, v = a number from 2 to 6, and X' is a ligand having a hydrolysable M-X bond or a combination thereof).

A coating solution containing an organic solvent and a first organometallic compound represented by the Formula RSnO_{(3/2-x/2)}(OH)ₓ (where 0 < x < 3), in which the solution contains from about 0.0025 M to about 1.5 M of tin, R is an alkyl group or a cycloalkyl group having 3 to 31 carbon atoms, and the alkyl or cycloalkyl group is bonded to tin at a secondary or tertiary carbon atom.

An inorganic pattern forming precursor aqueous solution containing a mixture of water, a metal suboxide cation, a polyatomic inorganic anion, and a radiation-sensitive ligand containing a peroxide group.

The irradiation with the light or electron beam is performed, for example, through a mask (reticle) for forming a predetermined pattern.

The exposure amount and the irradiation energy of the electron beam are not particularly limited.

Post exposure bake (PEB) may be performed after irradiation with the light or electron beam and before development.

The baking temperature is not particularly limited, but is preferably 60°C to 150°C, more preferably 70°C to 120°C, and particularly preferably 75°C to 110°C.

The baking time is not particularly limited, but is preferably 1 second to 10 minutes, more preferably 10 seconds to 5 minutes, and particularly preferably 30 seconds to 3 minutes.

For the development, for example, an alkaline developer is used.

Examples of the development temperature include 5°C to 50°C.

The developing time is, for example, 10 seconds to 300 seconds.

Examples of the alkaline developer include alkaline aqueous solution such as inorganic alkalis (for example, sodium hydroxide, potassium hydroxide, sodium carbonate, sodium silicate, sodium metasilicate, or aqueous ammonia); primary amines (for example, ethylamine or n-propylamine); secondary amines (for example, diethylamine or di-n-butylamine); tertiary amines (for example, triethylamine or methyldiethylamine); alcohol amines (for example, dimethylethanolamine or triethanolamine); quaternary ammonium salts (for example, tetramethylammonium hydroxide, tetraethylammonium hydroxide, or choline); and cyclic amines (for example, pyrrole or piperidine). Furthermore, it is also possible to add an appropriate amount of an alcohol, such as isopropyl alcohol, or a nonionic surfactant to the above alkaline aqueous solution. Among these, preferred developers are an aqueous solution of a quaternary ammonium salt, more preferably an aqueous solution of tetramethylammonium hydroxide and an aqueous solution of choline. Furthermore, a surfactant or the like can be added to these developers. A method of performing development with an organic solvent such as butyl acetate instead of the alkaline developer, and developing a part where the alkali dissolution rate of the photoresist is not improved can also be used.

Next, the resist underlayer film is etched using the formed resist pattern as a mask. The etching may be dry etching or wet etching, but is preferably dry etching.

Examples of the etching gas used for dry etching include fluorine-based gases such as CHF₃, CF₄, C₂F₆, C₃F₈, and SF₆; chlorine-based gases such as Cl₂ and BCl₃; oxygen-based gas such as O₂, O₃, and H₂O; reducing gases such as H₂, NH₃, CO, CO₂, CH₄, C₂H₂, C₂H₄, C₂H₆, C₃H₄, C₃H₆, C₃H₈, HF, HI, HBr, HCl, NO, NH₃, and BCl₃; and inert gases such as He, N₂, and Ar. These gases may be used alone or in combination of two or more types thereof.

For example, JP 11-135476 A proposes a technique of etching an organic antireflection film using a mixed gas of an O₂ (oxygen) gas and a halogen-based gas.

When the inorganic film is formed on the surface of the used semiconductor substrate, the surface of the inorganic film is exposed, and when the inorganic film is not formed on the surface of the used semiconductor substrate, the surface of the semiconductor substrate is exposed. Thereafter, the semiconductor device can be manufactured through a step of processing the semiconductor substrate by a known method (dry etching method or the like).

### Examples

Hereinafter, the present invention will be described in detail with reference to Examples, but the present invention is not limited to these Examples at all.

### <Measurement of Molecular Weight>

The weight average molecular weight of the polymer shown in the following Synthesis Examples of the present specification is a measurement result by gel permeation chromatography (hereinafter abbreviated as GPC). For the measurement, a GPC apparatus manufactured by Tosoh Corporation was used, and measurement conditions and the like are as follows.
. GPC column: Shodex KF803L, Shodex KF802, Shodex KF801 [registered trademark] (Showa Denko K.K.)
· Column temperature: 40°C
· Solvent: dimethylformamide (DMF)
· Flow rate: 1.0 ml/min
· Standard sample: polystyrene (manufactured by Tosoh Corporation)

### <Reference Signs List>

The abbreviation of the compound has the following meaning.
· BzMA: benzyl methacrylate (the following structure) 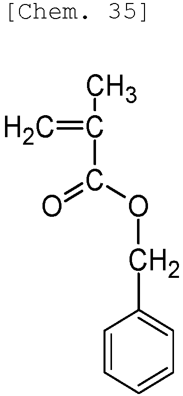
· HPMA: 2-hydroxypropyl methacrylate (the following structure) 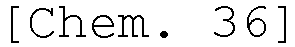 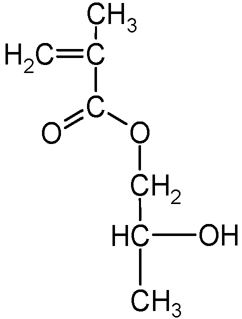
· GBLMA: γ-butyrolactone methacrylate (the following structure) 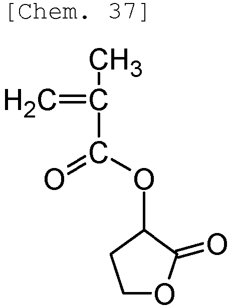
· PGME: propylene glycol monomethyl ether

### <Synthesis Example 1: BzMA/HPMA/GBLMA = 25/47/28 (wt%)>

In a reaction vessel, 0.68 kg of benzyl methacrylate, 0.66 kg of 2-hydroxypropyl methacrylate, and 0.66 kg of γ-butyrolactone methacrylate were dissolved in 7.0 kg of PGME, and the temperature was raised to 80°C while heating and stirring. 0.02 kg of azobisisobutyronitrile dissolved in 1.0 kg of PGME was added dropwise to the reaction vessel over 1 hour under nitrogen pressure, and then the reaction was allowed to occur for 24 hours. After the reaction, the mixture was cooled to obtain a polymer solution having a solid content of 20% by mass.

The composition ratio of the obtained polymer is BzMA/HPMA/GBLMA = 25/47/28 (wt%).

The obtained polymer had a weight average molecular weight of 89,000 and a number average molecular weight of 30,000.

### <Synthesis Example 2: BzMA/HPMA/GBLMA = 25/47/28 (wt%)>

Using BzMA, HPMA, and GBLMA as monomers, polymerization was performed with reference to Reference Example B-3 and Example B-3 of WO2012/053434 to obtain a polymer solution having a solid content of 20% by mass.

The composition ratio of the obtained polymer is BzMA/HPMA/GBLMA = 25/47/28 (wt%).

The obtained polymer solution had a weight average molecular weight of 10,500 and a number average molecular weight of 5,300.

### <Comparative Example 1>

1.885 kg of tetramethoxymethyl glycoluril (Nippon Cytec Industries, Inc., product name: POWDERLINK [registered trademark] 1174) and 0.118 kg of pyridinium-p-toluenesulfonate were mixed with 38.0 kg of the solution containing 7.7 kg of the polymer obtained in Synthesis Example 1. The obtained mixture was dissolved in 440.67 kg of propylene glycol monomethyl ether and 52.83 kg of propylene glycol monomethyl ether acetate to prepare a solution, thereby preparing a composition for forming a resist underlayer film.

### <Examples 1>

0.729 kg of tetramethoxymethyl glycoluril (Nippon Cytec Industries, Inc., product name: POWDERLINK [registered trademark] 1174) and 0.0455 kg of pyridinium-p-toluenesulfonate were mixed with 15.2 kg of the solution containing 3.0 kg of the polymer obtained in Synthesis Example 2. The obtained mixture was dissolved in 188.25 kg of propylene glycol monomethyl ether and 22.05 kg of propylene glycol monomethyl ether acetate to prepare a solution, thereby preparing a composition for forming a resist underlayer film.

### <Evaluation of DLS>

Dynamic light scattering measurement of each polymer solution obtained in Synthesis Example 1 and Synthesis Example 2 was performed.

The dynamic light scattering measurement was performed using a dynamic light scattering photometer DLS-8000Ar (manufactured by Otsuka Electronics Co., Ltd.). Measurement was performed at a scattering angle of 90° using a He-Ne laser (optical wavelength: 633 nm) as incident light, and an autocorrelation function was obtained. With respect to the obtained autocorrelation function, the average particle size and the polydispersity index was determined by cumulant analysis using an analysis program attached to the above measuring apparatus. Particle size distribution analysis was performed by the Contin method. The results are shown in Table 1.

As shown in Table 1, it was confirmed that when the polymer solution obtained in Synthesis Example 2 was used, the average particle size and the polydispersity index were smaller than those in Synthesis Example 1.

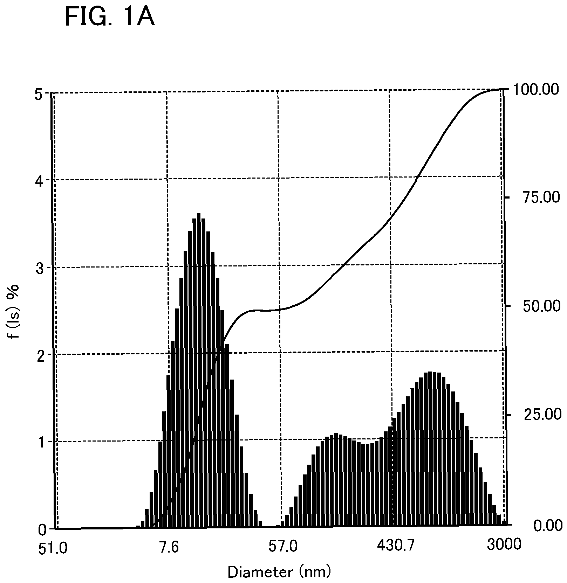

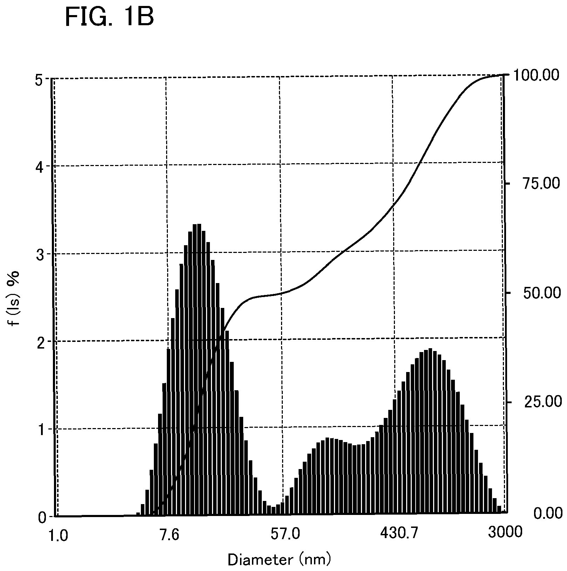

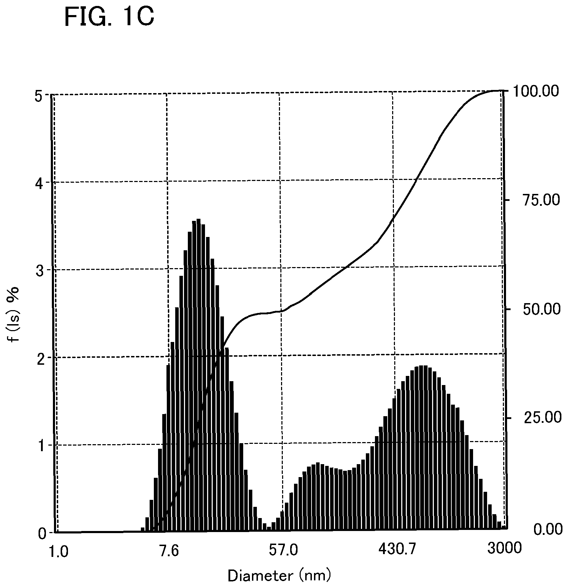

Figs. 1A to 1C show particle size distributions of samples 1st, 2nd, and 3rd of Synthesis Example 1, respectively.

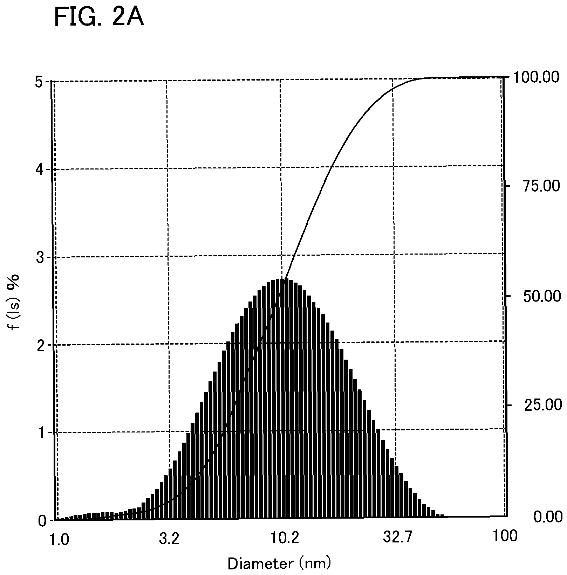

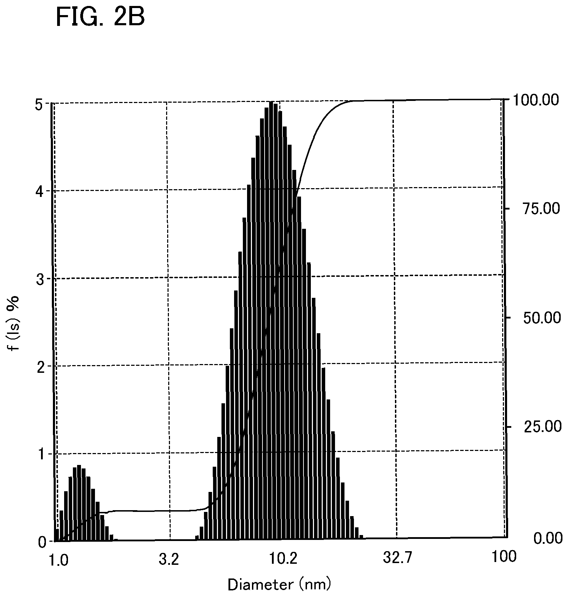

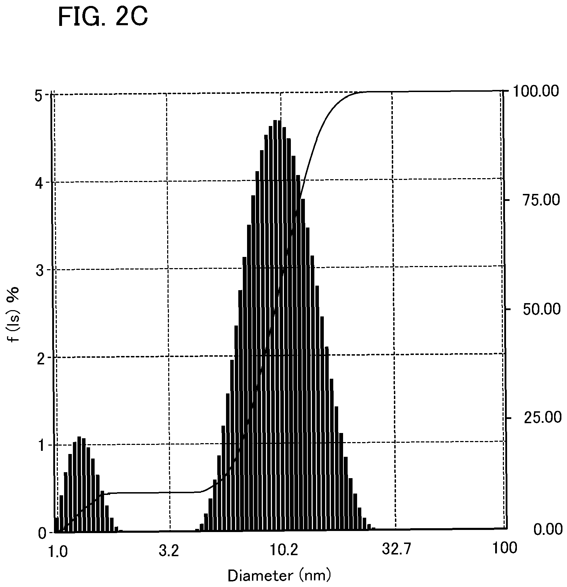

Figs. 2A to 2C show particle size distributions of samples 1st, 2nd, and 3rd of Synthesis Example 2, respectively.

Note that "f(ls)%" in Figs. 1A to 1C and Figs. 2A to 2C represents a scattering intensity distribution. The vertical axis (second axis) on the right side represents the integrated value of the scattering intensity distribution.

As shown in Figs. 1A to 1C and Figs. 2A to 2C, it was confirmed that even when comparing particle size distributions, the distribution of a larger particle size was significantly smaller in Synthesis Example 2.

**[Table 1]**

| Sample | | Average particle size (nm) | Polydispersity index | Peak number | Arithmetic average of average particle size of 3 samples (nm) |
|---|---|---|---|---|---|
| Synthesis Example 1 | 1st | 158.8 | 0.319 | 3 | 158.1 |
| | 2nd | 157.8 | 0.321 | 3 | |
| | 3rd | 157.8 | 0.318 | 3 | |
| Synthesis Example 2 | 1st | 9.3 | 0.185 | 2 | 9.1 |
| | 2nd | 9.0 | 0.225 | 2 | |
| | 3rd | 9.1 | 0.212 | 2 | |

### <Etching Defect Evaluation>

Etching defect evaluation was performed as follows. An Etching defect evaluation substrate (Poly Si: 150 nm/SiO₂: 80 nm/Si) was coated with each of the compositions for forming a resist underlayer film obtained in Comparative Example 1 and Example 1.

On a hot plate, heating was performed at 205°C for 1 minute to form a resist underlayer film (film thickness: 55 nm) .

This film was subjected to Etching using a chlorine-based mixed gas in an Etching apparatus manufactured by Lam Research Corporation. Thereafter, the number of defects (per 110 nm up: 81 cm²) after Etching was confirmed using a Defect inspection apparatus (manufactured by KLA-Tencor Corporation, trade name: SP1-DLS). The results are shown in Table 2.

As shown in Table 2, in the case of the sample of Example 1, it was confirmed that the Cone defect number (the number of fine particulate etching residues) was smaller than that of the sample of Comparative Example 1.

**[Table 2]**

| | Cone defect number |
|---|---|
| Comparative Example 1 | 2575 |
| Example 1 | 463 |

## Claims

1. A composition for forming a resist underlayer film containing a polymer having a repeating unit (1) represented by Formula (1) below and a repeating unit (2) other than the repeating unit (1), and a solvent, wherein
an average particle size of the polymer in a polymer solution containing the polymer is 50 nm or less: 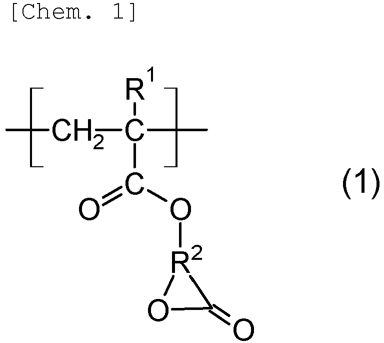
wherein, in Formula (1), R₁ represents a hydrogen atom, a methyl group, or a halogen atom, and R₂ represents a trivalent hydrocarbon group having 3 to 6 carbon atoms; and here, the lactone structure containing R₂ is a 5-membered ring or a 6-membered ring.

2. The composition for forming a resist underlayer film according to claim 1, wherein the repeating unit (2) includes a repeating unit (2A) represented by Formula (2A) below: 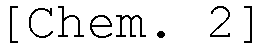 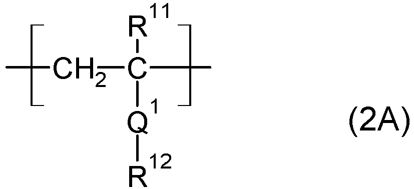 wherein, in Formula (2A), R¹¹ represents a hydrogen atom, a methyl group, or a halogen atom, Q¹ represents a single bond or a divalent linking group, and R¹² represents a hydrogen atom or a monovalent organic group.

3. The composition for forming a resist underlayer film according to claim 1, wherein the repeating unit (2) includes a repeating unit (2A-1) represented by Formula (2A-1) below and a repeating unit (2A-2) represented by Formula (2A-2) below: 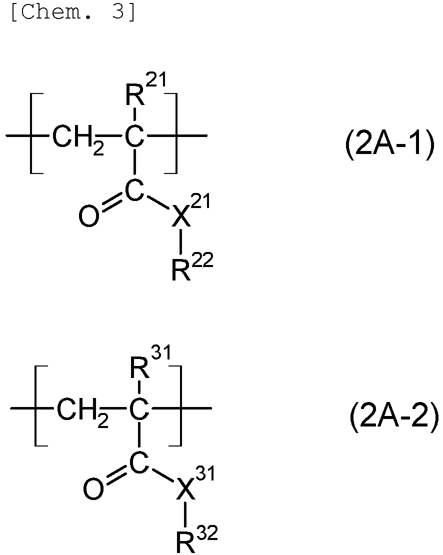
wherein, in Formula (2A-1), X²¹ represents -O- or -N(-R)- (R represents a hydrogen atom or an alkyl group having 1 to 4 carbon atoms), R²¹ represents a hydrogen atom, a methyl group, or a halogen atom, and R²² represents a substituted or unsubstituted alkyl group having 1 to 10 carbon atoms; and
in Formula (2A-2), X³¹ represents -O- or -N(-R)- (R represents a hydrogen atom or an alkyl group having 1 to 4 carbon atoms), R³¹ represents a hydrogen atom, a methyl group, or a halogen atom, and R³² represents a substituted or unsubstituted aralkyl group, a substituted or unsubstituted carbocyclic aromatic group, or a substituted or unsubstituted heterocyclic aromatic group.

4. The composition for forming a resist underlayer film according to claim 3, wherein
in the polymer, a weight ratio of the repeating unit (1) to all repeating units is 1 to 75% by weight, and
in the polymer, the total weight ratio of the repeating unit (2A-1) and the repeating unit (2A-2) to all total repeating units is 25 to 99% by weight.

5. The composition for forming a resist underlayer film according to claim 1, wherein the polymer has a weight average molecular weight of 50,000 or less.

6. The composition for forming a resist underlayer film according to claim 1, further containing a crosslinking agent.

7. The composition for forming a resist underlayer film according to claim 1, further containing a curing catalyst.

8. A resist underlayer film which is a cured product of the composition for forming a resist underlayer film according to any one of claims 1 to 7.

9. A semiconductor processing substrate comprising:
a semiconductor substrate; and
the resist underlayer film according to claim 8.

10. A method for manufacturing a semiconductor element, the method comprising:
a step of forming a resist underlayer film on a semiconductor substrate using the composition for forming a resist underlayer film according to any one of claims 1 to 7; and
a step of forming a resist film on the resist underlayer film.

11. A pattern forming method comprising:
a step of forming a resist underlayer film on a semiconductor substrate using the composition for forming a resist underlayer film according to any one of claims 1 to 7;
a step of forming a resist film on the resist underlayer film;
a step of irradiating the resist film with light or electron beam, and then developing the resist film to obtain a resist pattern; and
a step of etching the resist underlayer film using the resist pattern as a mask.
